# EUROPÄISCHE PATENTSCHRIFT

(11) **EP 3 900 011 B1**
(45) Veröffentlichungstag und Bekanntmachung des Hinweises auf die Patenterteilung: **22.05.2024**
(21) Anmeldenummer: 19817245.4
(22) Anmeldetag: 05.12.2019
(51) Int. Cl.: H01J 37/32, C23C 14/32, C23C 14/02, H01J 37/34

(54) **MAGNETANORDNUNG FÜR EINE PLASMAQUELLE ZUR DURCHFÜHRUNG VON PLASMABEHANDLUNGEN**
MAGNET ARRANGEMENT FOR A PLASMA SOURCE FOR CARRYING OUT PLASMA TREATMENTS
ENSEMBLE AIMANT CONÇU POUR UNE SOURCE DE PLASMA POUR RÉALISER DES TRAITEMENT AU PLASMA

(30) Priorität: 21.12.2018 US 201862783387 P; 26.02.2019 CH 2362019
(43) Veröffentlichungstag der Anmeldung: 27.10.2021
(73) Patentinhaber: Oerlikon Surface Solutions AG, Pfäffikon, 8808 Pfäffikon (CH)
(72) Erfinder: VETTER, Jörg, 51429 Bergisch Gladbach (DE)
(74) Vertreter: IPS Irsch AG
(86) Internationale Anmeldenummer: PCT/EP2019/083898
(87) Internationale Veröffentlichungsnummer: WO 2020/126531

(56) Entgegenhaltungen:
- WO-A2-2006/099758
- DE-C1- 4 125 365
- US-A1- 2004 055 538

## Beschreibung

### TECHNISCHES GEBIET

Die vorliegende Erfindung betrifft ganz allgemein eine Plasmaquelle und im Speziellen eine Plasmaquelle mit einer Magnetanordnung

### HINTERGRUND

Zum einen kann die elektrische Glimmentladung zur Plasmaerzeugung, die auf den Durchgang eines Stromes durch ein Gas durch das Anlegen einer hinreichend hohen Spannung zwischen einer Kathode und einer Anode, wie zum Beispiel Argon oder ein anderes Edelgas bei definierten niedrigen Drücken gebildet wird, eingesetzt werden. Zum anderen kann die Plasmaerzeugung eines Gases oder Gasgemisches in Form eines Niederdruckplasmas durch die Wechselwirkung hochenergetischer Elektronen mit Gasen erfolgen, die durch eine Elektronenquelle bereitgestellt werden und durch geeignete Elektroden auf definierte Energien beschleunigt werden, genutzt werden. Eine solche Elektronenquelle kann beispielsweise ein kathodischer Vakuumbogenverdampfer bestehend aus einer geeignet abgeschirmten Bogenkathode und einer die Bogenelektronen aufnehmende Bogenanode sein. Zur Gasplasmaerzeugung werden diese Bogenelektronen mit geeigneten Elektroden abgesogen und dabei hochenergetisch beschleunigt. Das dadurch erzeugte Gasplasma kann für unterschiedliche Plasmabehandlungen von Substraten genutzt werden. Beispielsweise dienen dadurch erzeugte Inertgasionen (z.B.) Argonionen einer lonenreinigung der Substrate. Im Plasma angeregte, gegebenenfalls zerlegte chemische Verbindungen sowie atomisierte Moleküle der Gase und Gasgemische können zur thermochemischen Behandlung von Substraten oder gar zur Schichtabscheidung eingesetzt werden. Dabei gilt es, die lokale Plasmaerzeugung definiert hinsichtlich der Behandlungsziele mit geeigneten Elektroden in Form, Anordnung und Betriebsparametern einzustellen. Ein Ziel ist dabei die Elektroden so auszuführen, dass diese nicht störend in den Behandlungsraum ragen und mit hohen Leistungsdichten beaufschlagbar sind und möglichst einfach zu warten sind. Weiterhin besteht das Ziel der Erfindung darin, das Plasma an den das Gasplasma erzeugenden Elektroden mittels von geeigneten Magnetfeldern zumindest an einer in die Behandlungskammer eingebrachten Elektrode zeitlich und örtlich einstellbar zu gestalten, wodurch die örtliche und zeitliche Plasmaverteilung im Behandlungsraum einstellbar wird. US 2004055538 A1 offenbart eine Vakuum-Lichtbogen-Beschichtungsvorrichtung mit einer rechteckigen Kathode, in der fokussierende Leiter vorgesehen sind, die ein Magnetfeld erzeugen, um einen kontinuierlichen magnetischen Pfad zu schaffen, der den Plasmastrom einschliesst. WO 2006/099758 A2 offenbart eine Vakuumbehandlungsvorrichtung, bei der ausserhalb der Kammer Magnetspulen zur magnetischen Bündelung eines Niederspannungs-Lichtbogenplasmas zwischen Plasmaquelle und Hilfsanode vorgesehen sind.

### BESCHREIBUNG DER VORLIEGENDEN ERFINDUNG

Die Erfindung betrifft eine Vakuumkammer zur Durchführung einer Plasmabehandlung umfassend einen Plasmabehandlungsbereich, der von Kammerwänden der Vakuumkammer umschlossen ist, sowie eine Plasmaquelle. Hierbei umfasst die Plasmaquelle mindestens eine in der Vakuumkammer angeordnete Kathode zur kathodischen Vakuumbogenverdampfung mit einer Bogenanode welche mit der Vakuumkammer verbunden ist und mindestens eine in der Vakuumkammer angeordnete Elektrode. Vor der Kathode kann eine Abschirmung angeordnet werden und die Elektrode besitzt eine Arbeitsoberfläche zum Auffangen der von der Kathode emittierten Elektronen welche dadurch gekennzeichnet ist, dass die Arbeitsoberfläche eine zweidimensionale Oberfläche zum Auffangen der von der Kathode emittierten Elektronen ist. Die zweidimensionale Oberfläche hat eine zu einer Oberflächennormale erste orthogonale Ausdehnung und eine zweite orthogonale Ausdehnung, wobei die erste orthogonale Ausdehnung senkrecht zu der zweiten orthogonalen Ausdehnung verläuft und ein Längenverhältnis der ersten orthogonalen Ausdehnung zu der zweiten orthogonalen Ausdehnung zwischen 0,1 und 1 liegt. Dabei ist ein Magnet zum Erzeugen eines Magnetfeldes welches auf die Arbeitsoberfläche der Elektrode einwirkt, in, an oder in und an der Vakuumkammer angeordnet.

Der Magnet umfasst einen vorderseitigen Magneten und / oder einen rückseitigen Magneten. Der vorderseitige Magnet ist im Bereich der Arbeitsoberfläche zum Erzeugen eines vorderseitigen Magnetfeldes angeordnet und der rückseitige Magnet ist hinter der Arbeitsoberfläche zum Erzeugen eines rückseitigen Magnetfeldes angeordnet. Der erfindungsgemässe Magnet kann als ein Magnetkreis, also als eine Spule oder eine Vielzahl von Magneten, ausgestaltet sein. Der Magnetkreis umschliesst die Arbeitsoberfläche, beziehungsweise ist vor der Arbeitsoberfläche angeordnet, Besonders bevorzugt umfasst eine erfindungsgemässe Elektrode ein ganzes Magnetsystem, umfassend einen vorderseitigen und einen rückseitigen Magnetkreis.

In Ausführung der Erfindung kann eine beliebige Anzahl von Elektroden und Kathoden in der Vakuumkammer angeordnet sein. Hierbei kann an jeder Elektrode ein Magnet angeordnet sein oder nur an einer Teilmenge einer Vielzahl von Elektroden. Hierbei können an den Elektroden rückseitige und / oder vorderseitige Magneten angeordnet sein.

Erfindungsgemäss ist mindestens ein Magnet zum Erzeugen eines Magnetfeldes an der Elektrode in der Vakuumkammer angeordnet. Hierbei können eine erste Elektrode eine zweite Elektrode vorliegen. Hierbei kann die erste Elektrode von einem ersten vorderseitigen Magnetfeld und die zweite Elektrode von einem zweiten vorderseitigen Magnetfeld beeinflusst werden. Auch ist es in Ausführung der Erfindung denkbar, dass die erste Elektrode ein erstes rückseitigen Magnetfeld und die zweite Elektrode ein zweites rückseitiges Magnetfeld hat. Bei mehreren Elektroden kann ein Teil der Elektroden (beziehungsweise eine erste Elektrode) ein rückseitiges Magnetfeld haben, während ein anderer Teil der Elektroden (beziehungsweise eine zweite Elektrode) ein vorderseitiges Magnetfeld hat. Liegen mehrere Elektroden vor können diese vorzugsweise an einem gemeinsam Netzteil angeschlossen sein, oder können selbstverständlich auch an verschiedene Netzteile (Stromquellen) angeschlossen sein. Ein Magnet an einer erfindungsgemässen Vakuumkammer kann ein Permanentmagnetsystem und/oder einen Elektromagneten umfassen. Umfasst der Magnet einen Elektromagneten kann der Elektromagnet als an die Elektrode gekoppelte, elektromagnetische Spule ausgestaltet sein. Liegt eine Vielzahl von Elektroden vor, so kann eine beliebige Anzahl der Elektroden ein einstellbares Magnetfeld haben. Einstellbare Magnetfelder gemäss der Erfindung können unter anderem durch verschiedene Stromstärken, eine spezifische Magnetanordnung und verschiedene Polaritäten einstellbar sein. Liegen mehrere Magnete vor können die Polaritäten der Magnete, insbesondere des rückseitigen oder vorderseitigen Magnets umkehrbar sein. Die erfindungsgemässe Elektrode kann insbesondere ein Verdampfer sein, welcher mindestens ein Metall umfasst. All die vorrangehend beschriebenen Massnahmen können unter andrem dazu dienen, die Homogenität des Plasmas einzustellen und zu beeinflussen. Dies kommt daher, da die Entladung sich zusätzlich bei einer oder mehreren Elektroden durch ein Magnetfeld verändern lässt. Dabei kann durch das Betreiben von mehreren Elektroden mit je einer Stromversorgung die Homogenität bei Beibehaltung der stärkeren Plasmaanregung durch die Vorgabe und Anpassung von Stromwerten gesteuert werden. Durch die Einstellung der Homogenität des Plasmas und folglich durch die erfindungsgemässen Magnetfelder ist beispielsweise auch die Ätzrate und Ätzhomogenität einstellbar. Insbesondere kann ein Ätzprofil auch durch Steuerung von Spulen und/oder Anordnung der Magnete beeinflusst werden.

Als Elektronquellen können typische industrielle kathodische Vakuumbogenverdampfer verwendet werden. Vor einem kathodischen Vakuumbogenverdampfer (später auch einfach Bogenverdampfer), der als Elektronenquelle verwendet wird, kann eine Abschirmung vorgesehen sein, die derart ausgestaltet ist, dass sie dem Wärmeeintrag durch die Vakuumbogenverdampfung standhält. Die Dimensionierung einer Fläche einer solchen Abschirmung sollte grösser sein als die gesamte Fläche der kathodischen Vakuumbogenverdampfer, welche eine zu verdampfende Oberfläche umfasst, um eine Bedampfung der Substrate zu vermeiden.

Eine oder mehrere Elektronen sammelnde Elektroden könnten in Form von ungekühlten Elektroden verwendet werden. Die Verwendung von ungekühlten Elektroden kann jedoch zu einer Limitierung der Leistung führen, mit welcher die Elektroden beaufschlagt werden können. Daher werden vorteilhafter gekühlte Elektroden, zum Beispiel wassergekühlte Elektroden verwendet.

Als Energieversorgung für die Elektroden können eine oder mehrere typische (Lichtbogen-) Netzgeräte verwendet werden, die eine Spannung von bis zu 100V und einen Strom von bis zu 400A liefern können. Hierbei können bei entsprechender Dimensionierung der Arbeitsoberfläche und Betriebsart an den Elektroden Stromdichten zwischen 0,1 bis 5 A/cm² und Leistungsdichten zwischen 0,25 bis 500 W/cm² erreicht werden.

In der Kammer sollte ein totaler Gasdruck in einem Bereich von 0,01 Pa bis 5 Pa während der Plasmabehandlung aufrechterhalten werden, bevorzugt ein Gasdruck im Bereich von 0,1 Pa bis 2 Pa. Typische Gase sind dabei Argon, Wasserstoff, Stickstoff oder Kohlenwasserstoffgase (z.B. C₂H₂, Acetylen), die je nach Behandlungsziel als reine Gase oder Gasmischungen eingesetzt werden.

Die erfindungsgemässe Vakuumkammer kann sowohl die Vielzahl von Elektroden, als auch die Vielzahl von Kathoden, insbesondere kathodischen Vakuumbogenverdampfern, umfassen. Hierbei können mehrere Kathoden eine einzige Abschirmung oder mehrere Abschirmungen besitzen. Mehrere Kathoden, insbesondere kathodische Vakuumbogenverdampfer, mit der einen Abschirmung können dabei vorteilhaft mit mindestens einer Elektrode in der Vakuumkammer angeordnet sein. Insbesondere kann in der Vakuumkammer auch eine gleiche Anzahl von Elektroden und Kathoden (insbesondere kathodischen Vakuumbogenverdampfern), mehr Elektroden als Kathoden (insbesondere kathodische Vakuumbogenverdampfer), oder mehr Kathoden (insbesondere kathodische Vakuumbogenverdampfer) als Elektroden umfassen. Die Elektroden und Kathoden können hierbei an verschiedenen Stellen in der Vakuumkammer (Wände, Decke, Boden) angeordnet sein. Sowohl über die Anordnung als auch über die Anzahl der Elektroden und Kathoden (insbesondere kathodischen Vakuumbogenverdampfer), kann die Plasmaverteilung in der Vakuumkammer eingestellt werden. Ausserdem kann so zum Beispiel in einem lonenätzprozess eine Verbesserung der Ätztiefe und / oder der Ätzhomogenität an einem Substrat erreicht werden. Die Verwendung von mehr als einer Elektrode erlaubt den Einsatz von verschiedenen Strömen an den Elektroden sowie eine Zeit selektive Anwendung der Ströme, sodass seine verbesserte Kontrolle der Plasmaerzeugung ermöglicht wird.

Der Elektronenstrom an der Elektrode kann durch eine Anpassung der Elektrodenspannung eingestellt werden. Niedrige Elektrodenspannungen resultieren in einem niedrigen Elektronenstrom und einer niedrigen Plasmaaktivität.

Ein typischer maximaler Elektronenstrom an der einen oder den mehreren Elektroden sollte bei ungefähr 120% des Stromes des kathodischen Vakuumbogenverdampfers gewählt werden. Zum Beispiel: Wenn in einer Vakuumkammer, die Argon bei einem Argon Druck on 0,5 Pa enthält, ein kathodischer Vakuumbogenverdampfer als Elektronenquelle verwendet wird, wobei der kathodische Vakuumbogenverdampfer bei einem Bogenstrom von 100 A betrieben wird, sollte der gesamte Elektrodenstrom auf ungefähr 120 A eingestellt werden. Das heisst, dass der Strom an der einen Elektrode, bzw. wenn mehr als eine Elektrode verwendet wird die Summe der einzelnen Ströme an den einzelnen Elektroden, auf maximal 120 A eingestellt werden sollte. Bevorzugt ist ein Elektrodenstrom, der kleiner oder gleich dem Bogenstrom ist.

Wenn eine Vielzahl von Elektroden (mehr als eine Elektrode) entlang einer Kammerwand derart angeordnet sind, dass sie über die Höhe der Vakuumkammer verteilt sind, kann jede Elektrode an einem separaten Netzteil oder an einer bestimmten Gruppe von Netzteilen betrieben werden, so dass die Elektroden umgeschaltet werden können, um sie mit einem maximalem Strom zu betreiben oder um sie parallel mit einem maximalen Strom zu betreiben, indem verschiedene Spannungen an die verschiedenen Elektroden angelegt werden. Typische Werte von Elektrodenspannungen liegen im Bereich von 10 V - 50 V und typische Elektrodenströme liegen im Bereich von 10 A - 200 A.

Die vorliegende Erfindung kann ausserdem zur Durchführung von Beschichtungsprozessen verwendet werden, zum Beispiel zum Aufbringen von Diamant ähnlichen Kohlenstoff (DLC) Schichten. Im Fall, dass eine DLC Schicht vom Typ a-C:H aufgebracht werden soll, sollte der Kammer eine Mischung aus einem Acetylen (C₂H₂) Gasfluss und einem Argon Gasfluss zugeführt werden.

Praktisch jede Beschichtungsvorrichtung, die für die Durchführung von Vakuumbeschichtungsprozessen ausgelegt ist, wie z.B. PVD-Bogenverdampfungsprozesse oder PVD-Sputterprozesse, einschliesslich HiPIMS, oder plasmaunterstützte chemische Abscheidungsprozesse (PA-CVD), kann für die Durchführung von Plasmabehandlungsprozessen gemäss der vorliegenden Erfindung angepasst werden.

Bei der erfindungsgemässen Anordnung soll in der Kammer der Magnet zum Erzeugen eines Magnetfeldes an der Elektrode angeordnet sein. Der Magnet kann dabei der vorderseitiger Magnet sein, welcher manuell steuerbar ist, sodass sein Magnetfeld verändert werden kann. Der vorderseitige Magnet könnte aber auch ein Permanentmagnet sein.

Bei der erfindungsgemässen Anordnung ist die Elektronenbeschleunigende Elektrode nicht räumlich linear im Sinne eines Verhältnisses zwischen der Länge der Elektrode und der Querschnitte, die häufig rechteckig bzw. kreisförmig oder elliptischen sind. Es werden im Wesentlichen zweidimensionale Elektroden verwendet. D.h. die zweidimensionale Oberfläche hat die zu der Oberflächennormale erste orthogonale Ausdehnung und die zweite orthogonale Ausdehnung, wobei die erste orthogonale Ausdehnung senkrecht zu der zweiten orthogonalen Ausdehnung verläuft. Das Längenverhältnis der ersten orthogonalen Ausdehnung zu der zweiten orthogonalen Ausdehnung liegt zwischen 0,1 und 1. Das Längenverhältnis der ersten orthogonalen Ausdehnung zu der zweiten orthogonalen Ausdehnung kann auch zwischen 0,2 und 1, insbesondere zwischen 0,4 und 1, in speziellen bei 1 liegen. Die Arbeitsoberfläche kann dabei im Bereich zwischen 5 bis 2000 cm², insbesondere 25 bis 320 cm² liegen. Die zweidimensionale Oberfläche kann kreisförmig, ellipsoidisch aber auch rechteckig sein oder andere geeignete Formen aufweisen. Ist die zweidimensionale Oberfläche kreisförmig entsprechen die erste orthogonale Ausdehnung und die zweite orthogonale Ausdehnung insbesondere dem Durchmesser der zweidimensionalen Oberfläche. Ist die zweidimensionale Oberfläche rechteckig entspricht die erste orthogonale Ausdehnung einer ersten Kantenlänge und die zweite orthogonale Ausdehnung einer zweiten Kantenlänge der zweidimensionalen Oberfläche. Ist die zweidimensionale Oberfläche ellipsoidisch entsprechen die erste orthogonale Ausdehnung und die zweite orthogonale Ausdehnung insbesondere Abständen von gegenüberliegenden Scheitelpunkten der zweidimensionalen Oberfläche. Zweidimensional nimmt unter anderen auch darauf Bezug, dass die Elektronen auf eine im Wesentlichen planare Fläche treffen. Die Fläche selbst kann jedoch durch die Herstellung oder Verwendung bedingt eine gewisse Strukturierung aufweisen. Diese Strukturierung kann durch Erosion der Elektrode bei einer Verwendung als Beschichtungsquelle, oder durch Reinigung der Elektrode über zum Beispiel Strahlen oder Schleifen auftreten. Dabei kann durch die Erosion, die Elektrode derart abgetragen werden, dass sie keine glatte beziehungsweise regelmässige Struktur / Rand mehr aufweist. Derart strukturierte und erodierte Elektroden werden im Rahmen der Erfindung auch als im Wesentlichen planar angesehen. Das Verhältnis zwischen einer maximalen Tiefe der Strukturierung und der kleineren orthogonalen Ausdehnung (in Bezug auf die erfindungsgemässe erste orthogonale Ausdehnung oder zweite orthogonale Ausdehnung) der zweidimensionalen Oberfläche der Elektrode beträgt maximal 0,4, insbesondere maximal 0,3, im speziellen maximal 0,2. Die maximale Tiefe der Strukturierung sollte also immer kleiner sein, als die kleinere orthogonale Ausdehnung. Hierbei weist die zwei-dimensionale Oberfläche der Elektrode vorzugsweise aktive Magnetfelder auf.

Im einfachsten Falle wird eine kreisförmige Elektrode betrieben, die vorzugsweise einen Elektrodendurchmesser von 100 mm besitzt. Hierbei kann die Elektrode, an einer Wand der Vakuumkammer befestigt sein und auch zumindest teilweise in der Kammerwand angeordnet sein. Ist die Elektrode zumindest teilweise in der Kammerwand angeordnet, hat dies den deutlichen Vorteil, dass die Elektrode nicht massgeblich in den Beschichtungsraum hineinragt. Wenn, wie vorrangehend beschreiben, mehrere zwei-dimensionale Elektroden vorliegen, können die Elektroden an unterschiedlichen Kammerwänden befestigt sein. Werden beispielsweise zwei zweidimensionale Elektroden eingebaut, sind die zwei zweidimensionalen Elektroden vorzugsweise an gegenüberliegenden Kammerwänden angeordnet. Selbstverständlich gibt es aber auch die Möglichkeit, dass mehrere zwei-dimensionale Elektroden, an benachbarten und / oder mehrere zwei-dimensionale Elektroden an der gleichen Kammerwand angeordnet sind. Dabei haben eine erste und eine zweite Elektrode vorzugsweise einen Abstand von 20 bis 400 mm, insbesondere von 100 bis 300 mm, im speziellen 200mm, wenn diese an einer Kammerwand übereinander oder nebeneinander betrieben werden.

Die Anordnung der zweidimensionalen Elektrode an einer Kammerwand hat dabei insbesondere folgende Vorteile gegenüber dem Stand der Technik mit einer linearen Elektrode innerhalb der Vakuumkammer. Der Plasmabehandlungsbereich innerhalb der Vakuumkammer, insbesondere im Zentrum der Vakuumkammer, bietet mehrfreien Raum. Durch diesen freien Raum kann somit eine bessere Nutzung der Kammer erreicht werden. Für eine bessere Nutzung der Kammer können die zu behandelnden Substrate innerhalb der Vakuumkammer besser verteilt werden, da durch den geschaffenen freien Raum in der Kammer mehr Platz zum Verteilen der zu behandelnden Substrate vorliegt. Hierdurch kann auch eine homogene Plasmabehandlung der Substratoberflächen ermöglicht werden, insbesondere wenn die zu behandelnden Substrate gleichmässiger in der Kammer angeordnet werden können. Ein weiterer Vorteil der erfindungsgemässen Anordnung ist, dass eine einfache Kühlung dieser erfindungsgemässen Elektroden ermöglicht wird. Eine zweidimensionale Oberfläche wie sie bei den erfindungsgemässen Elektroden vorliegt, ist selbstverständlich deutlich einfacher und effektiver kühlbar, als es bei einer linearen Elektrode möglich wäre. Die Kühlung der die Elektronen-aufnehmende Fläche kann direkt (wasserangeströmt) oder indirekt sein. Indirekt ist dabei das Klemmen eines geeigneten Elektrodenmaterials auf einen Kühlkörper.

Als Material der Kathode der Elektronenquelle auf der Basis eines kathodischen Vakuumbogenverdampfers (später auch einfach als Verdampfer bezeichnet), kann vorzugsweise ein Metall insbesondere Titan (Ti), Zirkonium (Zr) oder Aluminium (AI) sein. Selbstverständlich kann die das Material der Kathode auch aus einem anderen geeigneten Element, einer anderen geeigneten Legierung (Titanlegierungen und/oder Zirkoniumlegierungen und/oder Aluminium sowie Aluminiumlegierungen) oder einem anderen geeigneten Metall bestehen, welches eine Adsorption von Wasserstoff und / oder Sauerstoff begünstigt. Durch derartige Eigenschaften der Kathode des Vakuumbogenverdampfers kann unter anderem auch eine bessere Vakuumqualität für die Durchführung der Plasmaverfahren erreicht werden. Als Elektrodenmaterialien sind alle möglichen aus dem Stand der Technik bekannten Targetmaterialien der kathodischen Vakuumbogenverdampfer geeignet. Auch können als Elektrodenmaterial unter anderem Kohlenstofftargets verwendet werden, welche aus reinem Kohlenstoff oder Legierungen wie Kupferkohlenstofflegierungen. Auch als Elektrodenmaterial geeignet sind Stahl, Kupfer, Kupferlegierungen, Aluminium, Aluminiumlegierungen, oder leitfähige Verdampfermaterialien wie Aluminiumtitan, Chrom oder Vanadium.

In Ausführung der Erfindung kann eine Vielzahl von Elektroden in der Vakuumkammer angeordnet sein. Hierbei umfasst vorzugsweise jede Elektrode eine erfindungsgemässe Arbeitsoberfläche. Liegt eine erste und eine zweite Elektrode in der Vakuumkammer vor, kann ein zweiter vorderseitiger Magnet vor einer zweiten Arbeitsoberfläche der zweiten Elektrode angeordnet sein. Auch kann der zweite vorderseitige Magnet zumindest teilweise neben oder um die zweite Arbeitsoberfläche angeordnet sein. Des Weiteren kann der erste vorderseitige Magnet vor der ersten Arbeitsoberfläche angeordnet sein und / oder der erste vorderseitige Magnet zumindest teilweise neben oder um die erste Arbeitsoberfläche angeordnet sein.

Eine Polarität des erfindungsgemässen Magneten beziehungsweise der Magnetkreises kann beliebig angepasst werden. Hierbei können der vorderseitige und der rückseitige Magnet (beziehungsweise Magnetkreis) eine gleiche oder umgekehrte Polarität aufweisen. Bei der Vielzahl von Elektroden kann der erste vorderseitige Magnet eine gleiche Polarität wie der zweite vorderseitige Magnet besitzen. Zudem ist es möglich, dass eine erste Polarität des ersten vorderseitigen Magneten umgekehrt zu einer zweiten Polarität des zweiten vorderseitigen Magneten ist. Das gleich gilt auch für die rückseitigen Magneten. Insbesondere können die Magneten eine veränderbare Polarität haben.

In der Praxis können die erste Elektrode und die zweite Elektrode an ein gemeinsames Netzteil angeschlossen sein oder die erste Elektrode an ein erstes Netzteil und die zweite Elektrode an ein zweites Netzteil angeschlossen sein. Dabei kann insbesondere die Vielzahl von Elektroden eine erste Gruppe von Elektroden umfasst, welche mit einem ersten Netzteil verbunden ist und eine zweite Gruppe von Elektroden umfasst, welche mit einem zweiten Netzteil verbunden ist. Wenn die erste Elektrode und die zweite Elektrode mit dem gemeinsamen Netzteil verbunden sind, ist die veränderbare Polarität des ersten vorderseitige Magneten und/oder zweiten vorderseitige Magneten einstellbar, indem ein Strom der an den ersten Magnet und/oder an den zweiten Magnet angelegt wird, umgekehrt beziehungsweise reguliert wird.

### KURZE BESCHREIBUNG DER ZEICHNUNGEN

In allen Zeichnungen und in der gesamten Beschreibung bezeichnen gleiche Bezugszeichen die gleichen Elemente, Merkmale und Strukturen, ausser falls anders beschrieben. Die relative Grösse und Darstellung dieser Elemente kann, aus Gründen der Klarheit, Veranschaulichung oder Zweckmässigkeit nicht massgerecht sein.
Fig. 1 zeigt ein Beispiel einer bekannten Vakuumkammer zur Durchführung einer Plasmabehandlung.
Fig. 2 zeigt eine schematische Darstellung einer erfindungsgemässen Vakuumkammer zur Durchführung einer Plasmabehandlung mit einer Elektrode gemäss einem ersten Ausführungsbeispiel.

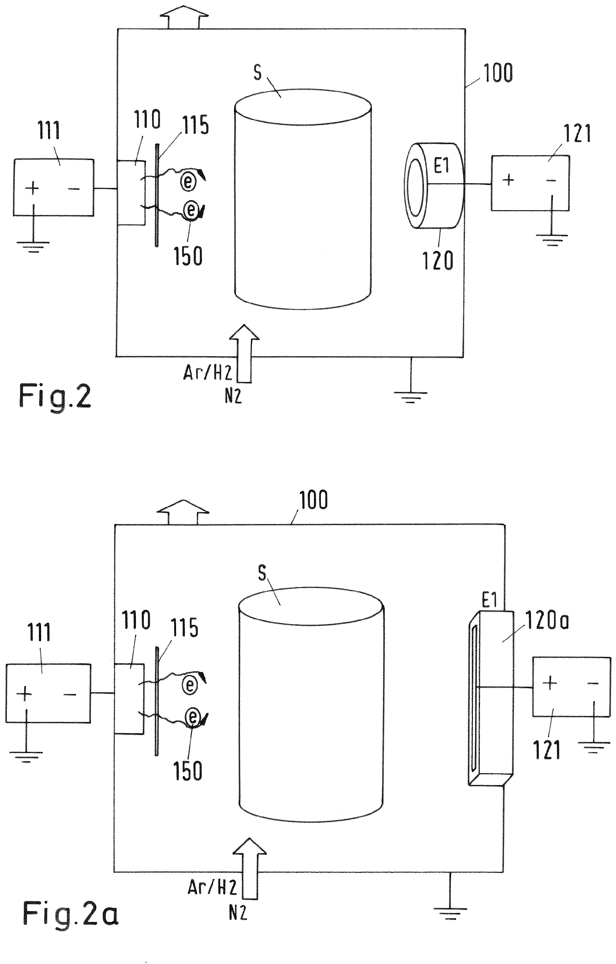

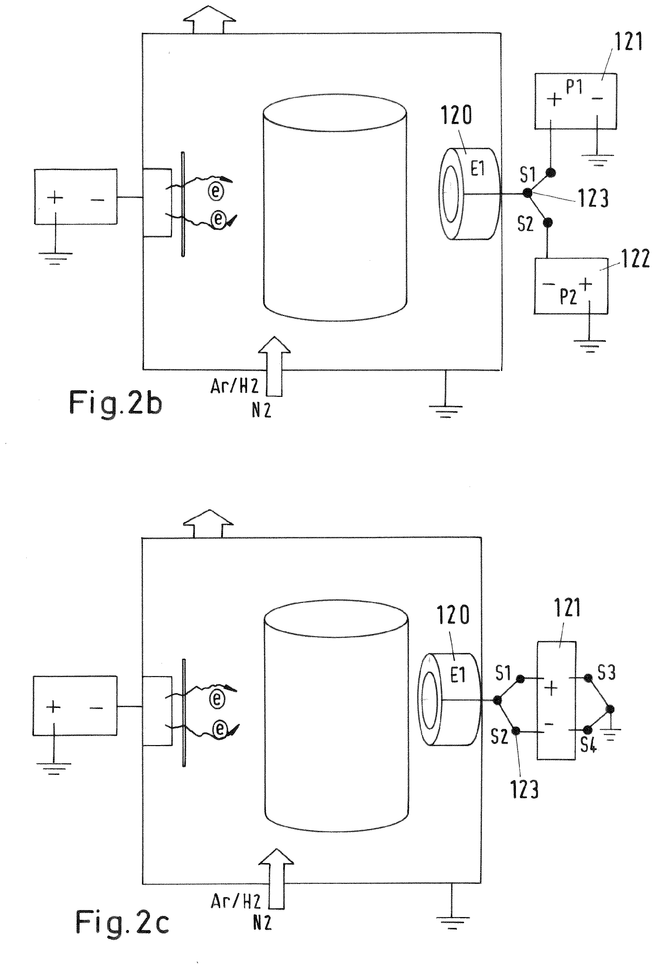

Fig. 2 a zeigt eine schematische Darstellung einer erfindungsgemässen Vakuumkammer zur Durchführung einer Plasmabehandlung mit einer rechteckigen Elektrode gemäss einem weiteren Ausführungsbeispiel.
Fig. 2 b zeigt eine schematische Darstellung einer erfindungsgemässen Vakuumkammer zur Durchführung einer Plasmabehandlung mit einer Elektrode mit einem Schalter zwischen Elektrode und Stromversorgung gemäss einem weiteren Ausführungsbeispiel.
Fig. 2 c zeigt eine schematische Darstellung einer erfindungsgemässen Vakuumkammer zur Durchführung einer Plasmabehandlung mit einer Elektrode mit einem Schalter zur Umpolung einer Stromversorgung gemäss einem weiteren Ausführungsbeispiel.

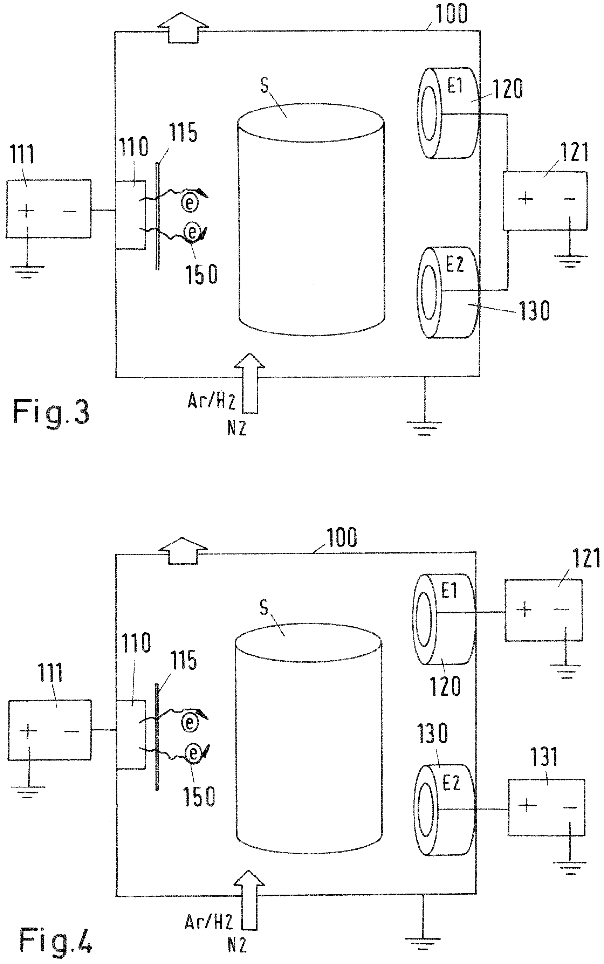

Fig. 3 zeigt eine schematische Darstellung einer erfindungsgemässen Vakuumkammer zur Durchführung einer Plasmabehandlung mit zwei erfindungsgemässen Elektroden mit einem Netzteil gemäss einem anderen Ausführungsbeispiel.
Fig. 4 zeigt eine schematische Darstellung einer erfindungsgemässen Vakuumkammer zur Durchführung einer Plasmabehandlung mit zwei erfindungsgemässen Elektroden mit zwei Netzteilen gemäss einem weiteren Ausführungsbeispiel.

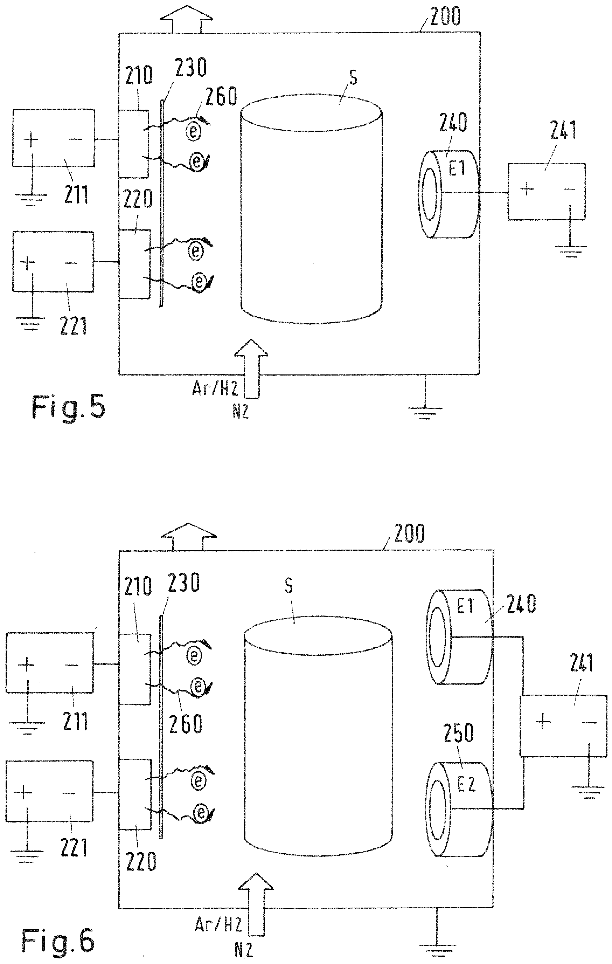

Fig. 5 zeigt eine schematische Darstellung einer erfindungsgemässen Vakuumkammer zur Durchführung einer Plasmabehandlung mit einer erfindungsgemässen Elektrode und zwei Kathoden gemäss einem weiteren Ausführungsbeispiel.
Fig. 6 zeigt eine schematische Darstellung einer erfindungsgemässen Vakuumkammer zur Durchführung einer Plasmabehandlung mit zwei erfindungsgemässen Elektroden und zwei Kathoden gemäss einem weiteren Ausführungsbeispiel.

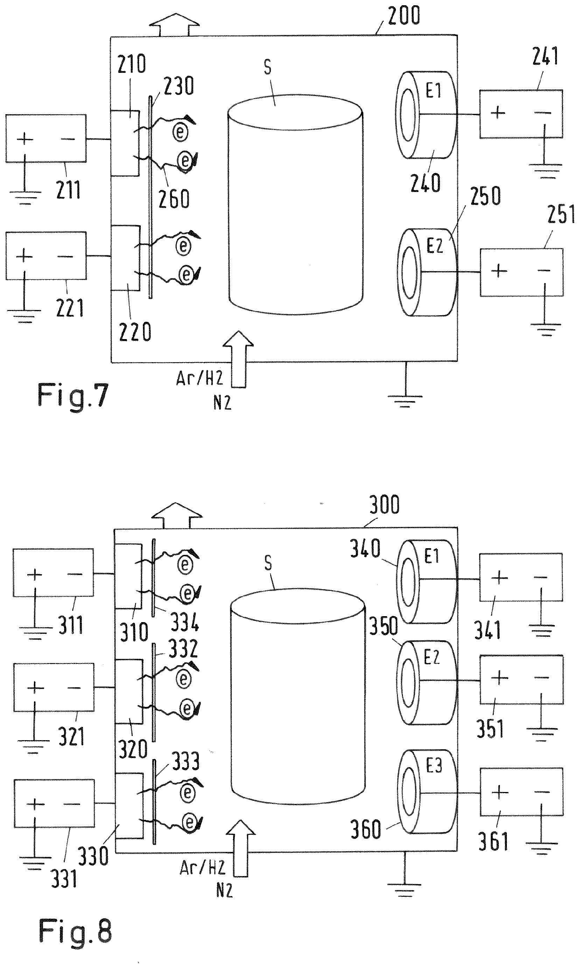

Fig. 7 zeigt eine schematische Darstellung einer erfindungsgemässen Vakuumkammer zur Durchführung einer Plasmabehandlung mit zwei erfindungsgemässen Elektroden und zwei Kathoden gemäss einem weiteren Ausführungsbeispiel.

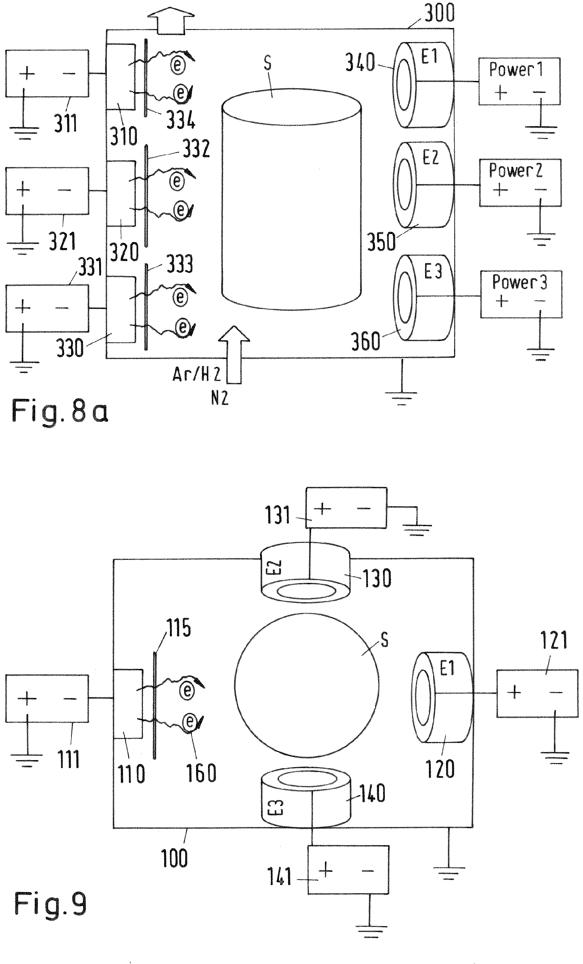

Fig. 8 zeigt eine schematische Darstellung einer erfindungsgemässen Vakuumkammer zur Durchführung einer Plasmabehandlung mit drei erfindungsgemässen Elektroden und drei Kathoden gemäss einem weiteren Ausführungsbeispiel.
Fig. 8 a zeigt eine schematische Darstellung einer erfindungsgemässen Vakuumkammer zur Durchführung einer Plasmabehandlung mit drei erfindungsgemässen Elektroden und drei Kathoden gemäss einem weiteren Ausführungsbeispiel.

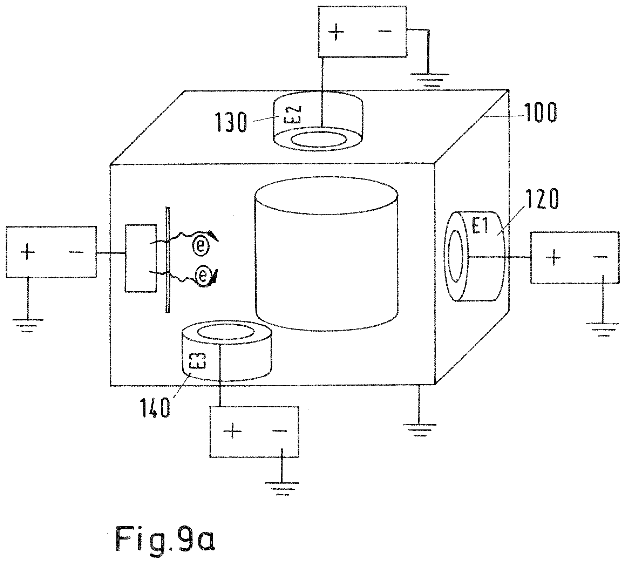

Fig. 9 zeigt eine schematische Darstellung einer erfindungsgemässen Vakuumkammer zur Durchführung einer Plasmabehandlung mit drei erfindungsgemässen Elektroden, an verschiedenen Kammerwänden gemäss einem anderen Ausführungsbeispiel.
Fig. 9 a zeigt eine schematische Darstellung einer erfindungsgemässen Vakuumkammer zur Durchführung einer Plasmabehandlung mit drei erfindungsgemässen Elektroden, an verschiedenen Kammerteilen gemäss einem anderen Ausführungsbeispiel.

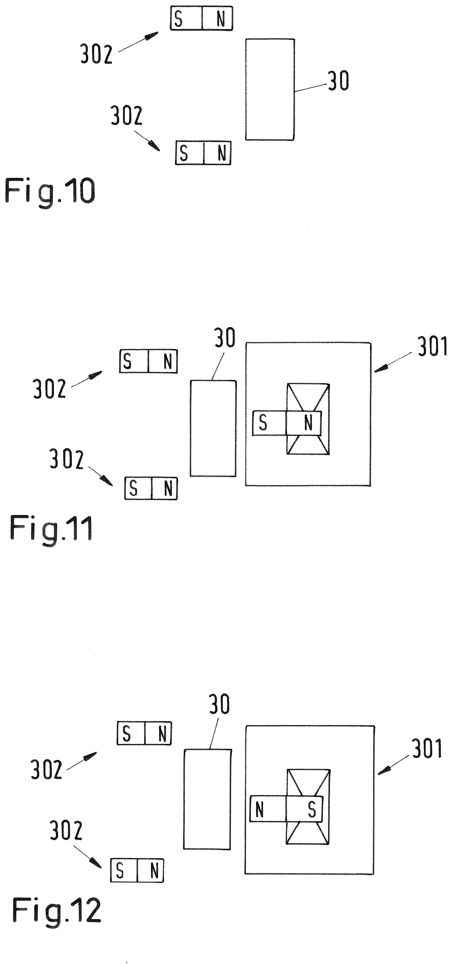

Fig. 10 zeigt eine schematische Darstellung einer erfindungsgemässen Vakuumkammer zur Durchführung einer Plasmabehandlung gemäss einem Ausführungsbeispiels der Erfindung mit einem vorderseitigen Magneten.
Fig. 11 zeigt eine schematische Darstellung einer erfindungsgemässen Vakuumkammer zur Durchführung einer Plasmabehandlung gemäss einem weiteren Ausführungsbeispiel mit einem vorderseitigen und rückseitigen Magneten.
Fig. 12 zeigt eine schematische Darstellung einer erfindungsgemässen Vakuumkammer zur Durchführung einer Plasmabehandlung gemäss einem anderen Ausführungsbeispiel mit einem vorderseitigen und rückseitigen Magneten.

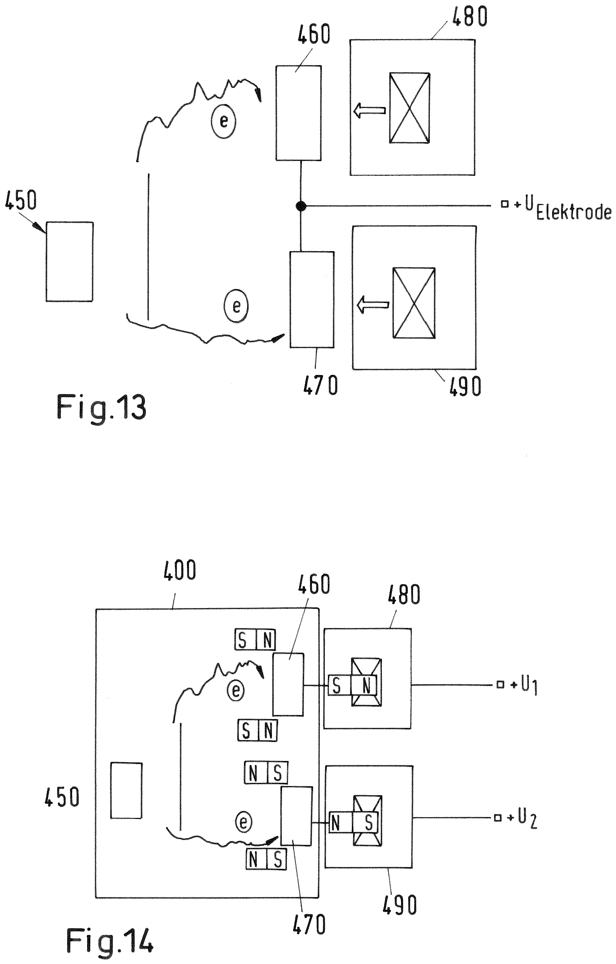

Fig. 13 zeigt eine schematische Darstellung einer magnetischen Feldkonfiguration für zwei Elektroden gemäss einem Ausführungsbeispiel.
Fig. 14 zeigt eine schematische Darstellung einer erfindungsgemässen Vakuumkammer zur Durchführung einer Plasmabehandlung mit zwei rückseitigen Magneten mit getrennten Stromversorgungen gemäss einem Ausführungsbeispiels.

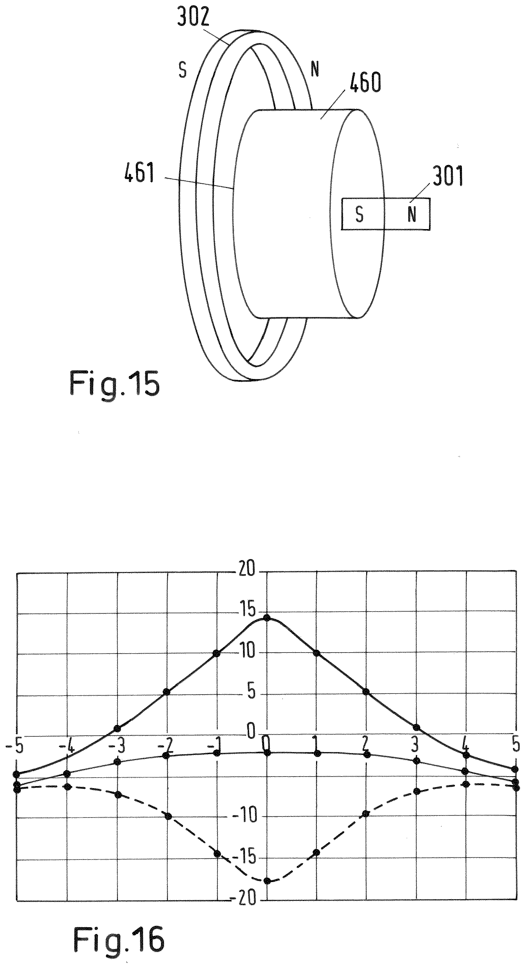

Fig. 15 zeigt eine schematische Darstellung einer Elektrodenanordnung mit einem vorderseitigen und rückseitigen Magneten gemäss einem weiteren Ausführungsbeispiel.
Fig. 16 zeigt ein Diagramm von Magnetfeldmessungen gemäss einem Ausführungsbeispiel.

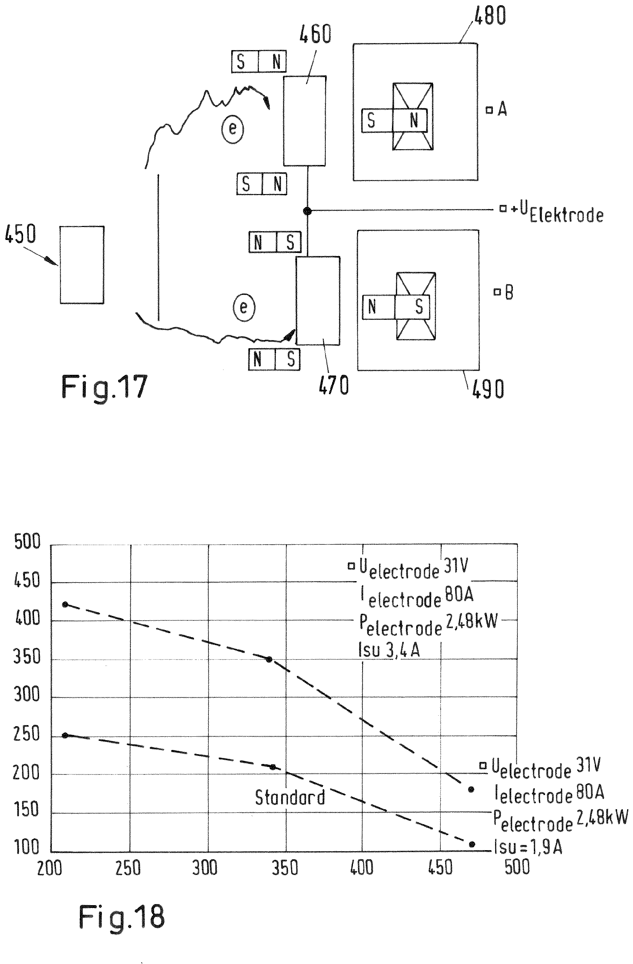

Fig. 17 zeigt eine schematische Darstellung einer magnetischen Feldkonfiguration für zwei Elektroden mit vorderseitigen und rückseitigen Magneten gemäss einem weiteren Ausführungsbeispiel.
Fig. 18 zeigt ein Diagramm einer Ätztiefe, der von Magnetfeldern gemäss einem Ausführungsbeispiel beeinflusst ist.

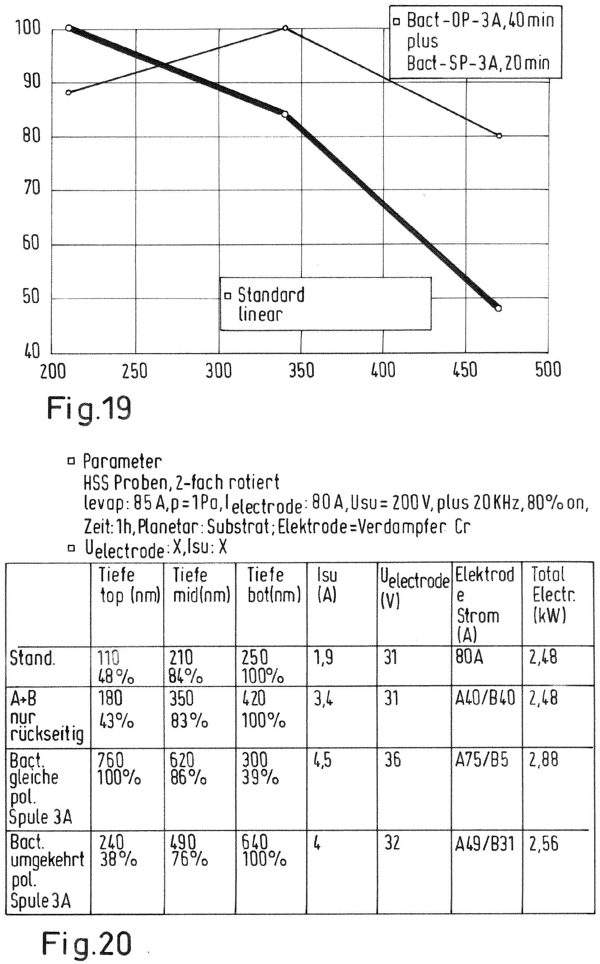

Fig. 19 zeigt ein Diagramm einer Ätztiefe gemäss einem erfindungsgemässen Beispielsystem.
Fig. 20 zeigt eine Tabelle von experimentellen Ergebnissen im Vergleich verschiedener Glimmentladungssysteme mit dem bekannten Stand der Technik.

### DETAILLIERTE BESCHREIBUNG

In den Zeichnungen sind Beispiele beschrieben, die ein oder mehrere Ausführungsbeispiele umfassen. Dabei ist die Erfindung nicht auf die beschriebenen Beispiele beschränkt. Zum Beispiel können ein oder mehrere Merkmale eines Ausführungsbeispiels auch in einem anderen Ausführungsbeispiel verwirklicht sein oder sogar in einem anderen Typ von Vorrichtung vorgesehen werden.

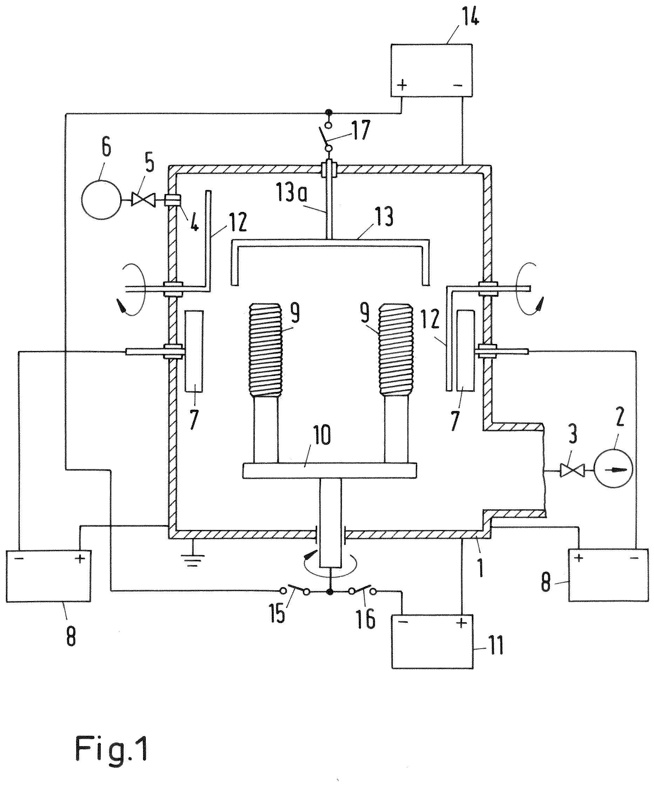

Bevor ein Beschichtungsprozess, wie zum Beispiel eine Beschichtung mittels physikalischer Gasabscheidung (PVD) oder eine diamantähnliche Kohlenstoffbeschichtung durchgeführt wird, kann ein Lichtbogen unterstützter Glimmentladungsprozess (auch lonenätzprozess) auf einem oder mehreren Substraten ausgeführt werden. Dabei wird der lonenätzprozess verwendet, um die Oberflächen vorzubereiten bzw. zu konditionieren, das heisst, die Substratoberflächen werden mittels eines Ionen Bombardements erhitzt und geäzt. Diese Konditionierung verbessert die Bindung zwischen dem Substrat und der Beschichtung. In Fig. 1 ist ein konventionelles lonenätzprozess System dargestellt. Das System umfasst eine Vakuumkammer 1 mit Verdampfern 7 (Verdampfer im Folgenden kurz für Bogenkathode eines kathodischen Vakuumbogenverdampfers), die an gegenüberliegenden Seiten der Kammer 1 angeordnet sind. Die Verdampfer 7 sind mit Gleichstromquellen 8 verbunden und können bei Spannungen von 40 V und Strömen bis zu 300 A betrieben werden. Shutter oder Abschirmungen 12 sind mit den Wänden der Kammer 1 verbunden und sind derart rotierbar angeordnet, dass die Shutter 12 so rotiert werden können, dass die entsprechende Elektrode 7 entweder abgeschirmt oder nicht abgeschirmt ist. Eine lineare Elektrode 13 ist mit der Kammer verbunden und gleich von den Verdampfern 7 beabstandet. Die lineare Elektrode 13 kann an die Stromquellen 11, 14 über Schalter 15, 16, 17 verbunden werden und besitzt im Betriebszustand eine gleiche Spannung längs der Elektrode 3. Die Stromquellen 11, 14 sind ausserdem mit der Wand der Kammer 1 verbunden und können wahlweise über die Schalter 15, 16 mit einem rotierbaren Substrathalter 10 verbunden werden. Über das Ventil 5 kann Gas, wie zum Beispiel Argon, von einer Gasquelle 6 über den Einlass 4 in die Kammer 1 eingelassen werden, wenn eine Lichtbogenentladung gezündet wird, werden vom Verdampfer 7 Elektronen erzeugt und in Richtung der linearen Elektrode 13 beschleunigt. Die Elektronen regen die Argongas Atome an und erzeugen so teilweise ionisierte Argonatome, die auf einer Oberfläche eines Substrats 9 abgesetzt werden um diese so für die Beschichtung vorzubereiten. Dieses System kann nur mittels der Gleichstromquellen 8, 11, 14 und dem rotierenden Substrathalter 10 eingestellt werden. Somit ist das System durch begrenzte lonisation, begrenzte Einstellbarkeit der Plasmaaktivierung durch die lineare Elektrode 13, sowie begrenzte Einstellbarkeit der Homogenität in der Kammer 1 gekennzeichnet.

Das Ausführungsbeispiel gemäss Fig. 2 zeigt eine schematisch dargestellte vakuumdichte Kammer 100, einen Verdampfer 110, welcher in der Kammer 100 vorgesehen ist und unmittelbar an der Wand der Kammer 100 angeordnet werden kann. Ausserdem ist ein Netzteil 111 vorgesehen, welches einen negativen Pol besitzt. Dieser negative Pol des Netzteils 111 oder der Stromquelle 111 ist mit dem Verdampfer 110 verbunden. Im vorliegenden Ausführungsbeispiel ist der Verdampfer 110 somit eine Kathode 110. Der Verdampfer 110 emittiert wie dargestellt Bogenelektronen, die mit der erfindungsgemässen Elektrode zunächst teilweise abgesogen und beschleunigt werden und somit das Arbeitsgas Argon (Ar) (oft auch Neon (Ne) oder irgendeinem anderen geeigneten Gas oder Mischung von Gasen) anregen und folglich ein Plasma erzeugen. Dazu wird an die Elektrode 120 eine positive Beschleunigungsspannung angelegt, die einen Elektrodenstrom zur Elektrode ermöglicht. Die Steuerung der Elektrode kann allgemein über die Spannung oder den Strom erfolgen, oder aber auch durch die Energie bestehend aus dem Produkt von Spannung und Strom erfolgen. Die Ionen des Plasmas treffen dann auf eine Oberfläche des Substrates S, welches vorzugsweise zentriert in der Kammer 100 vorgesehen ist, um dessen Oberflächen zum Beispiel durch Reinigung oder Ätzen für einen nachfolgenden Beschichtungsprozess vorzubereiten und zu aktivieren. In der Kammer 100 der Fig. 2 ist ausserdem eine Abschirmung 115 beweglich angeordnet, sodass die Abschirmung 115 wahlweise zwischen dem Verdampfer 110 und dem Substrat S positioniert werden kann. Somit kann vor der Zündung der kathodischen Vakuumbogenverdampfung die Abschirmung 115 entweder rotiert oder in anderer Weise vor den Verdampfer 110 bewegt werden, um das Substrat S vor Verunreinigungen durch den Verdampfer 110 während dieses Prozesses zu schützen. Wenn die kathodische Vakuumbogenverdampfung nicht vorhanden ist, kann die Abschirmung in eine andere geeignete Position bewegt werden.

Gemäss Fig. 2 ist eine einzige Elektrode 120 vorgesehen. Die Elektrode 120 ist mit einem positiven Pol eines Netzteils 121 verbunden und die Elektrode 120 ist folglich eine Anode 120. Durch die Verwendung von unterschiedlichen Strömen und / oder unterschiedlichen Zeitintervallen an der Stromquelle 121 der Anode 120 kann das im System erzeugbare Plasma beeinflusst werden.

Wie in Fig. 2 dargestellt, werden die vom Verdampfer 110 emittierten Elektronen zur Position der Elektroden/Anoden 120 entlang eines ersten und eines zweiten Elektronenweges 150 geführt. Somit ist wiederum ein in der Kammer 100 generierbares Plasma in dieselbe Richtung beschleunigbar. Durch geeignete Positionierung der ersten Elektrode 120 an einer gewünschten Position ist eine bessere / einfachere Kontrolle des Plasmaflusses in der Kammer 100 möglich und folglich eine verbesserte Kontrolle des Ionenbeschusses und Ätzens des Substrates.

Das Ausführungsbeispiel gemäss Fig. 2a zeigt eine schematisch dargestellte vakuumdichte Kammer 100 mit einem analogen Aufbau wie die Kammer 100 gemäss Ausführungsbeispiel gemäss Fig. 2. Die zweidimensionale Oberfläche zum Auffangen der von der Kathode emittierten Elektronen der ersten Elektrode 120a gemäss Fig. 2a ist jedoch rechteckig, wohingegen die zweidimensionale Oberfläche der ersten Elektrode 120 gemäss Fig. 2 kreisförmig ist. Hierbei besitzt die zweidimensionale Oberfläche zum Auffangen der von dem Verdampfer emittierten Elektronen, eine zu einer Oberflächennormalen erste orthogonale Ausdehnung und eine zweite orthogonale Ausdehnung, wobei die erste orthogonale Ausdehnung senkrecht zu der zweiten orthogonalen Ausdehnung verläuft und ein Längenverhältnis der ersten orthogonalen Ausdehnung zu der zweiten orthogonalen Ausdehnung zwischen 0,1 und 1 liegt. Bei der kreisförmigen Elektrode 120 entsprechen die erste orthogonale Ausdehnung und die zweite orthogonale Ausdehnung insbesondere dem Durchmesser der zweidimensionalen Oberfläche. Bei der rechteckigen Elektrode 120a entspricht die erste orthogonale Ausdehnung einer ersten Kantenlänge und die zweite orthogonale Ausdehnung einer zweiten Kantenlänge der zweidimensionalen Oberfläche.

Das Ausführungsbeispiel gemäss Fig. 2b zeigt eine schematisch dargestellte vakuumdichte Kammer 100 mit einem analogen Aufbau wie die Kammer 100 gemäss Ausführungsbeispiel gemäss Fig. 2. Das Ausführungsbeispiel gemäss Fig. 2b umfasst jedoch eine zwischen die erste Elektrode 120 und die Netzteile 121, 122 geschaltete Schaltervorrichtung 123. Das Netzteil 121 ist mit dem positiven Pol am Schalter S1 der Schaltervorrichtung 123 angeordnet und das Netzteil 122 ist mit dem negativen Pol am Schalter S2 der Schaltervorrichtung 123 angeordnet. Ist der Schalter S1 geschlossen und der Schalter S2 offen kann die Elektrode 120 als erfindungsgemässe Plasmaelektrode (also auch Anode) verwendet werden. Ist Schalter S1 offen und Schalter S2 geschlossen kann die Elektrode 120 für (Bogen-)Beschichtungsverfahren oder Sputterprozesse (also Target) verwendet werden.

Das Ausführungsbeispiel gemäss Fig. 2c zeigt eine schematisch dargestellte vakuumdichte Kammer 100 mit einem analogen Aufbau wie die Kammer 100 gemäss Ausführungsbeispiel gemäss Fig. 2. Das Ausführungsbeispiel gemäss Fig. 2c umfasst jedoch eine zwischen die erste Elektrode 120 und das Netzteile 121 geschaltete Schaltervorrichtung 123. Das Netzteil 121 ist mit dem positiven Pol am Schalter S1 der Schaltervorrichtung 123 angeordnet und mit dem negativen Pol am Schalter S2 der Schaltervorrichtung 123 angeordnet. Ausserdem ist das der positive Pol des Netzteils 121 über die einen Schalter S3 mit einer Erdung verbunden und der negative Pol des Netzteils 121 über die einen Schalter S4 mit der Erdung verbunden. Ist der Schalter S1 geschlossen, der Schalter S2 offen, der Schalter S3 offen und der Schalter S4 geschlossen, kann die Elektrode 120 als erfindungsgemässe Plasmaelektrode verwendet werden. Ist Schalter S1 offen und Schalter S2 geschlossen der Schalter S3 geschlossen und der Schalter S4 offen, kann die Elektrode 120 für (Bogen-)Beschichtungsverfahren oder Sputterprozesse verwendet werden.

Das Ausführungsbeispiel gemäss Fig. 3 zeigt die schematisch dargestellte vakuumdichte Kammer 100. Hierbei sind die erste Elektrode 120 und die zweite Elektrode 130 mit einem positiven Pol desselben Netzteils 121 oder derselben Stromquelle 121 verbunden. Folglich sind die erste Elektrode 120 und die zweite Elektrode 130 eine erste Anode 120 und eine zweite Anode 130. Durch die Verwendung von unterschiedlichen Strömen und / oder unterschiedlichen Zeitintervallen an der Stromquelle 121 der Anoden 120 und 130 kann das im System erzeugbare Plasma beeinflusst werden.

Da das gemeinsame Netzteil mit der ersten Elektrode 120 und der zweiten Elektrode 130 verbunden ist, kann mit dieser Anordnung eine gleiche Spannung an die erste Elektrode 120 und die zweite Elektrode 130 angelegt werden. Dieser Strom kann an beide Elektroden 120, 130 zur selben Zeit und für dieselbe Zeitdauer angelegt werden.

Das Ausführungsbeispiel gemäss Fig. 4 zeigt die schematisch dargestellte vakuumdichte Kammer 100. Bei dem Ausführungsbeispiel gemäss Fig. 4 ist an der ersten Elektrode 120 eine erstes Netzteil 121 und an der zweiten Elektrode 130 eine zweites Netzteil 131 angeordnet ist. Hierbei kann durch die Verwendung von unterschiedlichen Strömen und / oder unterschiedlichen Zeitintervallen an dem ersten Netzteil 121 und dem zweiten Netzteil 131 das im System erzeugbare Plasma beeinflusst werden, insbesondere da das erste Netzteil die erste Elektrode 120 mit einem ersten Strom versorgen und das zweite Netzteil kann die zweite Elektrode 130 mit einem zweiten Strom versorgen. Der erste und zweite Strom, können hierbei unabhängig voneinander einstellbar sein, sodass die Verteilung des Plasmas durch den ersten und den zweiten Strom formbar ist. Hierbei kann das erste Netzteil 121 die erste Elektrode 120 während eines ersten Zeitintervalls mit dem ersten Strom versorgen und das zweite Netzteil 131 die zweite Elektrode 130 während eines zweiten Zeitintervalls mit dem zweiten Strom versorgen. Das erste und das zweite Zeitintervall können je nach Wunsch voneinander getrennt oder überlappend sein.

In den Ausführungsbeispielen gemäss Fig. 2-4 liegt jeweils ein einziger Verdampfer 110 vor, wodurch ein Plasmabogen erzeugt wird, mit mindestens einer Anode 120, 130.

In Fig. 3, 4 und 9 sind Ausführungsbeispiele von Plasmaquellen schematisch dargestellt. Um den Fluss von Elektronen in der Kammer 100 (also eine erfindungsgemässe Vakuumkammer, im Folgenden als Kammer bezeichnet) besser kontrollieren zu können, sind, anders als bei der eine lineare Elektrode umfassenden Vorrichtung gemäss Fig. 1, eine Vielzahl von erfindungsgemässen Elektroden 120, 130, 140 mit einer zweidimensionale Oberfläche zum Auffangen der von einer Kathode emittierten Elektronen vorgesehen, die in der Kammer angeordnet werden können. Ein sehr wichtiger Vorteil dieser Anordnung besteht in der Möglichkeit die Elektroden an einer oder mehreren Wänden der Kammer zu positionieren, wodurch eine Verbesserung einer Verteilung der mit Plasma zu-behandelnden Substrate in der Kammer ermöglicht wird. Dadurch kann in der Kammer der Bereich zur Plasmabehandlung besser ausgenutzt werden, wodurch eine höhere Effizienz erzielt wird. Beispielsweise ist in Fig. 3 oder 4 eine vakuumdichte Kammer 100 schematisch dargestellt, Ein Verdampfer 110 ist in der Kammer 100 vorgesehen und kann unmittelbar in die Wand oder an die Wand der Kammer 110 angeordnet werden. Der Verdampfer 110 kann eines oder mehrere Metalle, wie zum Beispiel Titan und / oder jedes andere zur Verdampfung vorgesehene Metall umfassen. Ein negativer Pol des Netzteils oder der Stromquelle ist mit dem Verdampfer 110 verbunden und verbindet den Verdampfer 110 somit in Form einer Kathode. Wenn der Verdampfer 110 zum Beispiel mittels einer Triggereinheit gezündet wird, werden Bogenelektronen emittiert, welche mittels der erfindungsgemässen Elektrode beschleunigt werden und stossen mit einem oder mehreren Gasen wie zum Beispiel Argon (Ar), Neon (Ne) oder irgendeinem anderen geeigneten Gas oder Gasen zusammen, die in die Kammer 110 eingelassen wurden, und erzeugen so ein Plasma. Die Ionen des Plasmas bombardieren dann die Oberflächen des einen oder der mehreren Substrate (hier nicht gezeigt), die in der Kammer 100 vorgesehen sind, um deren Oberflächen zum Beispiel durch Reinigung oder Ätzen für einen nachfolgenden Beschichtungsprozess vorzubereiten. Eine oder mehrere Abschirmungen 115 sind in der Kammer 100 beweglich vorgesehen, so dass die Abschirmung 115 wahlweise zwischen dem Verdampfer 110 und dem Substrat positioniert werden kann. Somit kann vor der Zündung der kathodischen Vakuumbogenverdampfung die Abschirmung 115 entweder rotiert oder in anderer Weise vor den Verdampfer bewegt werden, um die Substrate vor Verunreinigungen durch den Verdampfer 110 während dieses Prozesses zu schützen. Wenn die kathodische Vakuumbogenverdampfung nicht vorhanden ist, kann die Abschirmung in eine andere geeignete Position bewegt werden.

Gemäss Fig. 3 und 4 sind zwei Elektroden, eine erste Elektrode 120 und eine zweite Elektrode 130 in der Kammer 100 vorgesehen. Die erste und zweite Elektrode 120, 130 sind mit einem positiven Pol des zumindest eines Netzteils oder Stromquelle verbunden und verbinden damit die erste und zweite Elektrode 120, 130 als erste und zweite Anode. Beispielsweise kann wie in Fig. 3 dargestellt ein gemeinsames Netzteil 121 mit der ersten Elektrode 120 und der zweiten Elektrode 130 verbunden werden. In dieser Anordnung kann eine gleiche Spannung an die erste Elektrode 120 und die zweite Elektrode 130 angelegt werden. Diese Spannung kann an beide Elektroden 120, 130 zur selben Zeit und für dieselbe Zeitdauer angelegt werden. Alternativ kann gemäss Fig. 4 ein erstes Netzteil 121 die erste Elektrode 120 während eines ersten Zeitintervalls mit einem Strom versorgen und ein zweites Netzteil 131 die zweite Elektrode 130 während eines zweiten Zeitintervalls mit einem Strom versorgen. Das erste und das zweite Zeitintervall können je nach Wunsch voneinander getrennt oder überlappend sein. In einem anderen Beispiel kann die erste Elektrode 120 mit einem ersten Netzteil 121 verbunden sein und die zweite Elektrode 130 kann mit einem zweiten Netzteil 131 verbunden sein. Somit kann das erste Netzteil 121 die erste Elektrode 120 mit einem ersten Strom versorgen und das zweite Netzteil 131 kann die zweite Elektrode 130 mit einem zweiten Strom versorgen. Durch die Verwendung von unterschiedlichen Strömen und / oder unterschiedlichen Zeitintervallen kann das im System erzeugte Plasma beeinflusst, gesteuert oder auch homogenisiert werden.

Wie in Fig. 3 und 4 dargestellt, fliessen die vom Verdampfer 110 emittierten Elektronen zu den Positionen der ersten und zweiten Elektroden 120, 130. Durch geeignete Positionierung der individuellen ersten Elektrode 120 und zweiten Elektrode 130 an den gewünschten Orten ist eine bessere Kontrolle des Plasmaflusses in der Kammer 100 möglich und folglich eine verbesserte Kontrolle des lonenbombardements und Ätzens des Substrats S. Fig. 9 illustriert ein Ausführungsbeispiel, bei welchem drei einzelne Elektroden, eine erste Elektrode 120, eine zweite Elektrode 130 und eine dritte Elektrode 140 vorgesehen sind. Somit resultiert ein entsprechender erster, zweiter und dritter Elektronenweg 160, der jeweils in Richtung der ersten, zweiten und dritten Elektrode 120, 130, 140 gerichtet ist. In den schematischen Zeichnungen gemäss Fig. 3 und 4 sind die Elektroden 120, 130 gegenüber dem Verdampfer 110 angeordnet. In der schematischen Zeichnungen gemäss Fig. 9 sind die Elektroden 120, 130, 140 hingegen an verschiedenen Kammerteilen angeordnet. Es versteht sich jedoch, dass jede geeignete Positionierung der ersten, zweiten oder optional auch dritten Elektrode möglich ist, um den Elektronenfluss derart zu beeinflussen, dass eine verbesserte Plasmaaktivierung und Homogenität in der Kammer erreichbar ist. Entsprechend ist jede Anzahl von Elektroden in der Kammer möglich, um den Elektronenfluss auf eine gewünschte Bahn zu lenken. Der Verdampfer 110 gemäss Fig. 3, 4 und 9 kann mit einem angelegten Strom von 100 A verwendet werden; jedoch kann selbstverständlich auch jede andere geeignete Stromstärke verwendet werden.

Fig. 5 zeigt ein weiteres Ausführungsbeispiel einer Kammer 200, bei welcher mehrere Verdampfer vorgesehen sind. Die Kammer 200 umfasst einen ersten Verdampfer 210 und einen zweiten Verdampfer 220, die als Kathoden angeschlossen sind, also mit einem negativen Pol einer ersten Netzteils 211 und eines zweiten Netzteils 221 verbunden sind. Der erste und zweite Verdampfer 210, 220 sind an der Wand der Kammer 200 vorgesehen. Alternativ kann der erste oder zweite Verdampfer 210, 220 auch an einer geeigneten Struktur der Wand der Kammer 200 oder in der Kammer 200 angeordnet sein. Eine rotierbare oder anders bewegbare Abschirmung 230 ist in der Nähe des ersten und zweiten Verdampfers 210, 220 vorgesehen. Die Abschirmung 230 kann eine Grösse haben, welche ausreicht, um beide Verdampfer 210, 220 abzuschirmen. Alternativ kann die Kammer 200 eine erste und zweite Abschirmung umfassen, die jeweils zum ersten Verdampfer und zum zweiten Verdampfer 210, 220 gehört (hier nicht gezeigt). Ausserdem ist in der Kammer 200 eine erste Elektrode 240 vorgesehen, welche als Anode angeschlossen ist, also mit dem positiven Pol einer ersten Stromquelle 241 verbunden ist. Wie durch die Elektronenwege 260 dargestellt, fliessen die vom ersten Verdampfer 210 emittierten Elektronen und die vom zweiten Verdampfer 220 emittierten Elektronen in Richtung der ersten Elektrode 240. Es versteht sich, dass jede gewünschte Anzahl von Verdampfern mit jeder gewünschten Anzahl von individuellen Elektroden benutzt werden kann, sodass das System eine geeignete Anzahl von Verdampfern und eine geeignete Anzahl von Elektroden umfassen kann.

Das Ausführungsbeispiel gemäss Fig. 6 zeigt eine schematisch dargestellte vakuumdichte Kammer 200 mit einem analogen Aufbau wie die Kammer 200 gemäss Ausführungsbeispiel gemäss Fig. 5. Das Ausführungsbeispiel gemäss Fig. 6 unterscheidet sich jedoch von Fig. 5 darin, dass eine erste Elektrode 240 und eine zweite Elektrode 250 vorliegen. Hierbei sind die erste Elektrode 240 und die zweite Elektrode 250 mit einem positiven Pol desselben Netzteils 241 oder derselben Stromquelle 241 verbunden. Folglich sind die erste Elektrode 240 und die zweite Elektrode 250 als eine erste Anode 240 und eine zweite Anode 250 geschaltet.

Da das gemeinsame Netzteil mit der ersten Elektrode 240 und der zweiten Elektrode 250 verbunden ist, kann in dieser Anordnung ein gleicher Strom an die erste Elektrode 240 und die zweite Elektrode 250 angelegt werden. Dieser Strom kann an beide Elektroden 240, 250 zur selben Zeit und für dieselbe Zeitdauer angelegt werden.

Fig. 6 zeigt ein weiteres Ausführungsbeispiel einer Plasmaquelle, bei welcher mehrere Verdampfer vorgesehen sind. Eine Kammer 200 umfasst einen ersten Verdampfer 210 und einen zweiten Verdampfer 220, die als Kathoden angeschlossen sind. Der erste und zweite Verdampfer 210, 220 kann in der Wand der Kammer 200 oder anders an der Kammer 200 vorgesehen sein. Alternativ kann der erste oder zweite Verdampfer 210, 220 auch an einer geeigneten Struktur der Kammer 200 oder in der Kammer 200 angeordnet sein. Eine rotierbare oder anders bewegbare Abschirmung 230 ist in der Nähe des ersten und zweiten Verdampfers 210, 220 vorgesehen. Die Abschirmung 230 kann eine Grösse haben, die ausreicht, um beide Verdampfer 210, 220 abzuschirmen. Alternativ kann die Kammer 200 eine erste und zweite Abschirmung umfassen, die jeweils zum ersten Verdampfer 110 und zum zweiten Verdampfer 220 gehört. Ausserdem ist in der Kammer 200 eine erste Elektrode 240 und eine zweite Elektrode 250 vorgesehen, welche beide als Anode angeschlossen sind. Wie durch die Elektronenwege 260 dargestellt, fliessen die vom ersten Verdampfer 210 emittierten Elektronen in Richtung zur ersten Elektrode 240 und die vom zweiten Verdampfer 220 emittierten Elektronen in Richtung zur zweiten Elektrode 250. Es versteht sich, dass jede gewünschte Anzahl von Verdampfern mit jeder gewünschten Anzahl von individuellen Elektroden benutzt werden kann. So kann das System der Fig. 6 zum Beispiel zwei Verdampfer und vier individuelle Elektroden umfassen, so dass Elektronen vom ersten Verdampfer 210 zu zwei individuellen Elektroden fliessen und die Elektronen vom zweiten Verdampfer zu zwei anderen individuellen Elektroden fliessen.

Das Ausführungsbeispiel gemäss Fig. 7 zeigt eine schematisch dargestellte vakuumdichte Kammer 200 mit einem analogen Aufbau wie die Kammer 200 gemäss Ausführungsbeispiel gemäss Fig. 6. Das Ausführungsbeispiel gemäss Fig. 7 unterscheidet sich jedoch von Fig. 6 darin, dass an der ersten Elektrode 240 ein erstes Netzteil 241 und an der zweiten Elektrode 250 eine zweites Netzteil 251 angeordnet ist. Hierbei kann durch die Verwendung von unterschiedlichen Strömen und / oder unterschiedlichen Zeitintervallen an des ersten Netzteils 241 und des zweiten Netzteils 251 das im System erzeugbare Plasma beeinflusst werden, insbesondere da das erste Netzteil die erste Elektrode 240 mit einem ersten Strom versorgen und das zweite Netzteil kann die zweite Elektrode 250 mit einem zweiten Strom versorgen. Der erste und zweite Strom können hierbei unabhängig voneinander einstellbar sein, sodass die Verteilung des Plasmas durch den ersten und den zweiten Strom formbar ist. Hierbei kann das erste Netzteil 241 die erste Elektrode 240 während eines ersten Zeitintervalls mit dem ersten Strom versorgen und das zweite Netzteil 251 die zweite Elektrode 250 während eines zweiten Zeitintervalls mit dem zweiten Strom versorgen. Das erste und das zweite Zeitintervall können je nach Wunsch voneinander getrennt oder überlappend sein.

In den Ausführungsbeispielen gemäss Fig. 5-7 liegen jeweils zwei Verdampfer 210, 220 vor mit mindestens einer Anode 240, 250.

Das Ausführungsbeispiel gemäss Fig. 8 kann insbesondere in grossen Systemen zur Anwendung kommen. Mehrere Plasmaquellen können in der Kammer vorgesehen sein, indem Verdampfer 311, 321, 331 und Elektroden 340, 350, 360 entlang der Höhe der Kammer, das heisst entlang der Höhe des Plasmabehandlungsbereichs angeordnet sind, wobei die Plasmaquelle in jedem Fall mindestens einen Verdampfer und eine, zwei oder mehr einzelne Elektroden umfasst. Dabei kann jede Elektrode von einem eigenen Netzteil versorgt werden oder aber ein schaltbares Netzteil kann von mehreren Elektroden gleichzeitig benutzt werden.

Die Kammer 300 der Fig. 8 umfasst dabei einen ersten Verdampfer 310, einen zweiten Verdampfer 320 und einen dritten Verdampfer 330, die als Kathoden angeschlossen sind, also mit einem negativen Pol eines ersten Netzteils 311, eines zweiten Netzteils 321 und eines dritten Netzteils 331 verbunden sind. Der erste, zweite und dritte Verdampfer 310, 320 und 330 sind an derselben Wand der Kammer 300 vorgesehen. Alternativ können der erste, zweite und dritte Verdampfer 310, 320 und 330 auch an einer geeigneten Struktur der Wand der Kammer 300 oder in der Kammer 300 angeordnet sein. Ausserdem können erste, zweite und dritte Verdampfer 310, 320 und 330 an verschiedenen Wänden, beziehungsweise erste und dritte Verdampfer 310 und 330 an einer Wand und der zweite Verdampfer 320 an einer anderen Wand. Drei rotierbare oder anders bewegbare Abschirmungen 334, 332 und 333 sind jeweils in der Nähe des ersten, zweiten und dritten Verdampfers 310, 320 und 330 vorgesehen. Alternativ kann die Kammer 300 eine Abschirmung umfassen, welche eine Grösse hat, welche ausreicht, um alle Verdampfer 310, 320, 330 abzuschirmen. Ausserdem ist in der Kammer 300 eine erste Elektrode 340, eine zweite Elektrode 350 und eine dritte Elektrode 360 vorgesehen, welche als Anoden 340, 350, 360 angeschlossen sind, also mit dem positiven Pol jeweils mit einem ersten Netzteil 341, einem zweiten Netzteil 351 und einem dritten Netzteil 361 verbunden ist. Wie durch die Elektronenwege dargestellt, fliessen die vom ersten Verdampfer 310 emittierten Elektronen, die vom zweiten Verdampfer 320 emittierten Elektronen und die vom dritten Verdampfer 330 emittierten Elektronen in Richtung der drei Anoden 340, 350, 360.

In der schematischen Zeichnung gemäss Fig. 8 sind die Elektroden 340, 350, 360 gegenüber dem Verdampfern 310, 320, 330 angeordnet. Es versteht sich jedoch, dass jede geeignete Positionierung der ersten, zweiten und dritten Elektrode möglich ist, um den Elektronenfluss derart zu beeinflussen, dass eine verbesserte Plasmaaktivierung und Homogenität in der Kammer erreichbar ist. Entsprechend ist jede Anzahl von Elektroden in der Kammer möglich, um den Elektronenfluss auf eine gewünschte Bahn zu lenken. Der an die Verdampfer 310, 320, 330 angelegte Strom kann 100 A betragen, jedoch kann selbstverständlich auch jede andere geeignete Stromstärke verwendet werden.

In dem Ausführungsbeispiel gemäss Fig. 8 liegen also drei Verdampfer 310, 320 und 330 vor mit drei Anoden 340, 350 und 360 vor.

Fig. 8 a zeigt ein weiteres Ausführungsbeispiel einer Kammer 300, mit einem analogen Aufbau zur Kammer in Fig. 8, jedoch werden die Netzteile der ersten Elektrode 340, der zweiten Elektrode 350 und der dritten Elektrode 360 mit verschiedenen Energien betrieben. Über die verschiedenen Energien kann unter anderem die Homogenität eines Plasmas verbessert werden, als auch die Verteilung eines Plasmas besser gesteuert werden, indem die Energien an den jeweiligen Netzteilen entsprechend eingestellt werden.

Wie aus den Fig. 4-8 erkenntlich kann das Substrat S sowohl negativ, als auch positiv vorgespannt werden, wobei die positive Vorspannung kleiner als die der Elektrode sein muss, da ansonsten die gesamten Elektronen zum Substrat fliessen. Selbstverständlich eignet sich ein entsprechend vorgespanntes Substrat auch zu zusätzlichen Plasmasteuerung. Ausserdem werden der Kammer 100, 200 im Betriebszustand ein Arbeitsgas und ein Prozessgas zugeführt. Das Arbeitsgas ist hierbei vorzugsweise Argon (Ar) und Wasserstoff (H2) und das Prozessgas vorzugsweise Stickstoff (N2).

Das Ausführungsbeispiel gemäss Fig. 9 zeigt eine schematisch dargestellte vakuumdichte Kammer 100 mit einem analogen Aufbau wie die Kammer 100 gemäss Ausführungsbeispiel gemäss Fig. 2. Das Ausführungsbeispiel gemäss Fig. 9 unterscheidet sich jedoch von Fig. 2 darin, dass eine erste Elektrode 120, eine zweite Elektrode 130 und eine dritte Elektrode 140 vorliegen und an der ersten Elektrode 120 einem ersten Netzteil 121, an der zweiten Elektrode 130 eine zweites Netzteil 131 und an der dritten Elektrode 140 eine drittes Netzteil 141 angeordnet ist. Hierbei kann durch die Verwendung von unterschiedlichen Energien und / oder unterschiedlichen Zeitintervallen an dem ersten Netzteil 121, dem zweiten Netzteil 131 und dem dritten Netzteil 141 das im System erzeugbare Plasma beeinflusst werden, insbesondere da das erste Netzteil 121 die erste Elektrode 120 mit einer ersten Energie versorgt und das zweite Netzteil131 kann die zweite Elektrode 130 mit einer zweiten Energie versorgen und das dritte Netzteil 141 kann die dritte Elektrode 140 mit einer dritten Energie versorgen. Die erste, zweite und dritte Energie können hierbei unabhängig voneinander einstellbar sein, sodass die Verteilung des Plasmas durch die erste, die zweite und die dritte Energie formbar ist.

Fig. 9 illustriert ein Ausführungsbeispiel, bei welchem also drei einzelne Elektroden, eine erste Elektrode 120, eine zweite Elektrode 130 und eine dritte Elektrode 140 vorgesehen sind. Somit resultiert ein entsprechender erster, zweiter und dritter Elektronenweg 160, der jeweils in Richtung der ersten, zweiten und dritten Elektrode 120, 130, 140 gerichtet ist. In den schematischen Zeichnungen gemäss Fig. 13 sind die Elektroden 120, 130, 140 gegenüber dem Verdampfer 110 angeordnet. Es versteht sich jedoch, dass jede geeignete Positionierung der ersten, zweiten oder optional auch dritten Elektrode möglich ist, um den Elektronenfluss derart zu beeinflussen, dass eine verbesserte Plasmaaktivierung und Homogenität in der Kammer erreichbar ist. Entsprechend ist jede Anzahl von Elektroden in der Kammer möglich, um den Elektronenfluss auf eine gewünschte Bahn zu lenken.

Das Ausführungsbeispiel gemäss Fig. 9a zeigt eine schematisch dargestellte vakuumdichte Kammer 100 mit einem analogen Aufbau wie die Kammer 100 gemäss Ausführungsbeispiel gemäss Fig. 9. Bei Ausführungsbeispiel gemäss Fig. 9a sind die Elektroden 120, 130, 140 jedoch nicht nur an Kammerwänden der Kammer 100 angeordnet. Die erste Elektrode 120 ist an einer Kammerwand angeordnet, die zweite Elektrode 130 ist an einer Kammerdecke angeordnet und die dritte Elektrode 140 am Kammerboden. Die Anordnung der Elektroden in der Kammer kann, um unter anderem eine Plasmaverteilung zu steuern, beliebig angepasst werden.

Während unterschiedliche beispielhafte Konfigurationen im Rahmen dieser Anmeldung gezeigt und beschrieben wurden, fallen natürlich auch weitere Ausführungsbeispiele mit jeglicher Anzahl von Verdampfern und jeglicher Anzahl von Elektroden in den Schutzbereich der hier beanspruchten Erfindung. Darüber hinaus kann eine erfindungsgemässe Vakuumkammer für lonenätzprozesse verwendet werden und mit einer Mehrzahl von einzelnen Elektroden ausgerüstet sein, wobei verschiedene Elektroden mit verschiedenen Strömen versorgt sein können. An die verschiedenen Elektroden können gleiche oder verschiedene Ströme, auch zu verschiedenen Zeiten angelegt werden, um die Plasmaaktivierung und das Ätzen in gewünschter Weise zu manipulieren.

Die in den Figuren enthaltenen Elektronenwege 150, 160, 260 sind nur schematisch dargestellt, da die Elektronenwege 150, 160, 260 selbstverständlich an den Abschirmungen 115, 230, 332, 333, 334 vorbeiführen und nicht durch diese hindurch.

In den Fig. 2 bis 9a ist in der Vakuumkammer, insbesondere in der Nähe der Elektroden, oder bei einer Vielzahl von Elektroden in der Nähe mindestens einer Elektrode dieser Vielzahl, ein Magnet zum Erzeugen eines Magnetfeldes angeordnet (hier nicht gezeigt). Dieser Magnet ist besonders bevorzugt an der Arbeitsoberfläche der Elektrode angeordnet. Im Allgemeinen kann der Magnet einen vorderseitigen Magneten und / oder einen rückseitigen Magneten umfassen. Der vorderseitige Magnet ist im Bereich der Arbeitsoberfläche zum Erzeugen eines vorderseitigen Magnetfeldes angeordnet und der rückseitige Magnet ist hinter der Arbeitsoberfläche zum Erzeugen eines rückseitigen Magnetfeldes angeordnet. Bei Vorliegen einer Vielzahl von Elektroden kann auch an einer Elektrode oder an einer Teilmenge der Vielzahl von Elektroden ein vorderseitigen und / oder ein rückseitiger Magnet angeordnet sein. Das Substrat S kann sowohl negativ, als auch positiv vorgespannt werden, wobei die positive Vorspannung kleiner als die der Elektrode sein sollte, da ansonsten die gesamten Elektronen zum Substrat fliessen. Im Betriebszustand kann als Arbeitsgas vorzugsweise Argon (Ar) und Wasserstoff (H2) und als Prozessgas vorzugsweise Stickstoff (N2) zugeführt werden.

Nun wenden wir uns den Fig. 10-12 zu, in welchen Ausführungsbeispiel gezeigt sind, bei denen Magnetfelder an die einzelnen Elektroden der Vakuumkammer angelegt werden können. In einem Magnetfeld kann ein Elektronenweg kontrolliert werden, was die geladenen Partikel im Plasma entsprechend beeinflusst. Genauer gesagt, wird die Diffusion der geladenen Partikel durch das Magnetfeld behindert. Dadurch wird der Verlust an Elektronen und Ionen reduziert und die Elektronendichte erhöht. Üblicherweise werden Elektromagnete in Form von Spulen um die Kammer herum von einem Ende zu einem gegenüberliegenden Ende positioniert, um ein Magnetfeld innerhalb der Kammer zu erzeugen. Andere konventionelle Systeme verwenden Permanentmagnete, die unterhalb des Substrats angeordnet sind und zur Erzeugung des Magnetfeldes bewegt werden. Jedoch erlaubt keine dieser Konfigurationen den Fluss der Elektronen derart zu kontrollieren, dass die Homogenität einstellbar und verbesserbar ist. Bei den hier beschriebenen Ausführungsbeispielen wird ein Magnetfeld an jede einzelne Elektrode angelegt. Fig. 10 zeigt ein Beispiel, bei welchem eine Elektrode 300 in der Nähe oder innerhalb eines Elektromagneten 302 angeordnet ist. Beispielweise kann der Elektromagnet 302 eine Spule sein, die um die Elektrode 30 gewickelt ist, also im Bereich einer Arbeitsoberfläche der Elektrode angeordnet ist. In diesem Fall ist das Magnetfeld an der Elektrode 30 vorderseitig. Kein rückseitiges Magnetfeld wurde erzeugt.

Die Fig. 11-12 zeigen Ausführungsbeispiele mit rückseitigen Magneten 320 und vorderseitigen Magneten 310. In Fig. 11 umfasst die Elektrode 30 die elektromagnetische Spule 302, die in der Nähe oder um die Elektrode 30 herum vorgesehen ist (also im Bereich der Arbeitsoberfläche und / oder zumindest teilweise neben der Arbeitsoberfläche angeordnet). Eine elektromagnetische Spule 301 ist in der Nähe der Elektrode 30 hinter der Arbeitsoberfläche positioniert, um als rückseitiger Magnet ein rückseitiges Magnetfeld zu erzeugen. Die elektromagnetische Spule kann einen ferritischen Kern oder aber auch keinen ferritischen Kern umfassen, abhängig von der gewünschten Magnetfeldstärke. Wie gezeigt sind die beiden Spulen 301, 302 so angeordnet, dass sie dieselbe Polarität haben. In Fig. 12 haben die Magnetfelder zwischen den elektromagnetischen Spulen 301 und 302 eine entgegengesetzte Polarität. Dieser Wechsel in der Polarität der (rückseitigen und vorderseitigen) Magnetfelder kann erreicht werden, indem die Richtung des Stromes durch die Spule 301 gewechselt wird. Somit ist das Magnetfeld an einer einzelnen Spule einstellbar. Das Diagramm der Fig. 16 zeigt ein Beispiel der Magnetfeldstärke (in mT, Y-Achse), die senkrecht zur Oberfläche (Runde Elektrode, 5cm Radius, Nullpunkt entspricht Zentrum der Elektrode, X-Achse Radius ausgehend von Elektrodenzentrum in cm) bei einem Spulenstrom von 3A gemessen wurde. Die mittlere Kurve zeigt die Stärke des Magnetfelds der Fig. 10, wobei kein rückseitiges Magnetfeld erzeugt wurde. Die obere Kurve zeigt die Stärke des Magnetfeldes gemäss Fig. 11, bei welcher das Magnetfeld durch Spulen erzeugt wurde, die gleich polarisiert sind; und die untere Kurve zeigt die Stärke des magnetischen Feldes gemäss Fig. 12, bei welcher das Magnetfeld durch Spulen erzeugt wurde, welche entgegengesetzt polarisiert sind. Bei der oberen Kurve liegt ein Tunnelfeld vor, da die obere Kurve ab ungefähr ±3,2 im negativen Bereich verläuft und somit das Magnetfeld ab diesem Radius eine umgekehrte Richtung aufweist. Bei der unteren Kurve hingegen, weist das aus der Arbeitsoberfläche austretende Magnetfeld nur eine Richtung auf.

Fig. 13 zeigt ein anderes Ausführungsbeispiel der vorliegenden Erfindung. Das in Fig. 13 gezeigte System, ist eine Vakuumkammer zur Durchführung einer Plasmabehandlung mit einer magnetischen Feldkonfiguration für zwei Elektroden. Ein Verdampfer 450 ist innerhalb der Kammer vorgesehen und kann direkt (zumindest teilweise) in die Kammerwand eingebettet oder mit dieser verbunden sein. Ein negativer Pol einer 100A Stromquelle kann mit dem Verdampfer verbunden sein und verbindet den Verdampfer damit als Kathode. Somit werden Elektronen emittiert, wenn der Verdampfer gezündet wird und die Elektronen kollidieren mit einem Argon (Ar) Gas, das in die Kammer eingeführt wurde und erzeugen so das Plasma. Die Ionen im Plasma bombardieren dann die Oberflächen von einem oder mehreren nicht gezeigten Substraten, die in der Kammer angeordnet sind um gereinigt und / oder geätzt zu werden. Eine oder mehrere Abschirmungen sind derart beweglich in der Kammer positioniert, dass die Abschirmung wahlweise zwischen dem Verdampfer und dem Substrat positioniert werden können. Somit kann die Abschirmung vor der Zündung der kathodischen Vakuumbogenverdampfer rotiert oder in anderer Weise vor den Verdampfer 450 bewegt werden, um das Substrat vor Verunreinigungen zu schützen. Wenn der durch den kathodischen Vakuumbogenverdampfer erzeugte Lichtbogen nicht vorhanden ist, können die Abschirmungen in eine nicht abschirmende Position bewegt werden. In einer erfindungsgemässen Kammer sollte zumindest eine einzelne Elektrode in der Kammer vorgesehen sein. In Fig. 13 sind jedoch eine erste Elektrode 460 und eine zweite Elektrode 470 vorgesehen, welche an einem positiven Pol eines (zum Beispiel 80A) Netzteils (auch Stromquelle) angeschlossen sind und verbindet die Elektroden 460, 470 somit als Anoden. Entsprechend fliessen die Elektronen von dem Verdampfer 450 in Richtung der Position der Elektroden 460, 470. Das Beschleunigt das generierte Plasma in dieselbe Richtung. Hinter den Arbeitsoberflächen der Elektroden 460, 470 ist ein erster rückseitiger Magnet 480 und ein zweiter rückseitiger Magnet 490 zum Erzeugen eines rückseitigen Magnetfeldes angeordnet. Die rückseitigen Magnetfelder können an die Elektroden mittels eines Elektromagneten angelegt werden, indem eine elektromagnetische Spule hinter der Arbeitsoberflächen der Elektroden 460, 470 angeordnet wird. Bei Benutzung von Elektroden mit Magnetfeldern, kann der ein Substratstrom erhöht, insbesondere verdoppelt werden bei einer in wesentlichen selben lonenätz-Performance, was in Folge zu einem erhöhten Ätzen des Substrates (der Substrate) führt.

Obwohl in Fig. 13 nur ein einzelner Verdampfer 450 gezeigt ist, kann (wie bereits in den Ausführungen zu Fig. 5-8a gezeigt) jede beliebige Anzahl von Verdampfern und auch Elektroden im System verwendet werden. Grössere Systeme und / oder grössere Kammern können zum Beispiel zwei oder mehr Verdampfer benötigen, um eine grössere Anzahl von Elektronen zu erzeugen.

Fig. 14 zeigt ein Beispiel einer Kammer 400 mit einem ähnlichen Aufbau wie das Ausführungsbeispiel gemäss Fig. 17. Im Unterschied zu Fig. 15 sind die erste Elektrode und die zweite Elektrode der Fig. 14 an unterschiedliche Stromversorgungen angeschlossen (Stromversorgung U1 und Stromversorgung U2). Hierdurch können die Polaritäten der beiden Spulen unabhängig voneinander gesteuert und geändert werden, wodurch selbstverständlich eine Verbesserung der ÄtzHomogenität erreicht werden kann.

In der Vakuumkammer 400 der Fig. 14 ist hierbei jeweils ein vorderseitiger Magnet (auch Magnetkreis) an der ersten Elektrode 460 und der zweiten Elektrode 470 angeordnet. Ausserdem ist an der ersten Elektrode 460 ein erster rückseitiger Magnet 480 angeordnet und an der zweiten Elektrode 470 ist ein zweiter rückseitiger Magnet 490 angeordnet. Wie vorrangehend beschrieben sind die rückseitigen Magnete 480, 490 an unterschiedliche Stromversorgungen angeschlossen (Stromversorgung 1 und Stromversorgung 2). Der vorderseitigen Magneten sind in der Vakuumkammer 400 (also unter Vakuum) angeordnet während die rückseitigen Magneten 480, 490 ausserhalb der Vakuumkammer 400 (also unter Atmosphärendruck) angeordnet sind. Es versteht sich, dass Magnete auch Permanentmagnete umfassen können. Wie vorrangehend beschrieben, sollte die erfindungsgemässe Vakuumkammer einen Magneten umfassen, welcher zum Erzeugen eines Magnetfeldes an, neben oder um die (zweidimensionalen) Arbeitsoberfläche der Elektrode in oder ausserhalb der (Vakuum-) Kammer angeordnet ist. Hierbei kann der Magnet einen vorderseitigen Magneten und / oder einen rückseitigen Magneten umfassen. In Fig. 15 ist hierbei der vorderseitige Magnet 302 im Bereich der Arbeitsoberfläche 461 zum Erzeugen eines vorderseitigen Magnetfeldes angeordnet und der rückseitige Magnet 301 hinter der Arbeitsoberfläche 461 zum Erzeugen eines rückseitigen Magnetfeldes angeordnet. Selbstverständlich kann der vorderseitige Magnet auch zumindest teilweise neben der Arbeitsoberfläche angeordnet sein. Sowohl der vorderseitige Magnet, als auch der rückseitige Magnet können als Elektromagneten, insbesondere als Spulen ausgestaltet sein. Durch Verwendung von Elektromagneten wird eine zeitliche Steuerung des Magnetfeldes (rückseitiges oder vorderseitiges, insbesondere resultierendes Magnetfeld bei Verwendung von rückseitigem und vorderseitigen) ermöglicht. Dabei kann das Magnetfeld sowohl gepulst werden, als auch deren Stärke bei im Wesentlichen gleicher Feldrichtung angepasst werden und auch die Feldrichtung umgekehrt werden. Durch Änderung der Stromrichtung in der Spule kann die Polarität des Magnetfeldes angepasst werden. Besonders bevorzugt können bei Verwendung der erfindungsgemässen Vakuumkammer Programme vorgegeben werden, bei welchen sich der Strom in den Spulen ändert. Hierbei kann zum Beispiel ein Strom von 3 A für ein erstes Zeitintervall verwendet werden und ein Strom von 3 A mit einer umgekehrten Stromrichtung für ein zweites Zeitintervall verwendet werden. Das erste und zweite Zeitintervall können gleich aber auch selbstverständlich unterschiedlich sein. Auch die Ströme können unterschiedlich stark sein. Zusammenfassend kann das durch die Spule erzeugte Magnetfeld über die Zeit, die Richtung und über die Stromstärke gesteuert werden.

Das erfindungsgemässe System kann auch eine Vielzahl von vorderseitigen und / oder rückseitigen Magneten also ein vorderseitiger und / oder rückseitiger Magnetkreis umfassen, die ringförmig angeordnet sind. Wie zum Beispiel in Fig. 15 gezeigt, kann der vorderseitige Magnet 302 ringförmig sein beziehungsweise eine Vielzahl von vorderseitigen Magneten 302 ringförmig als Magnetkreis angeordnet sein. Die Vielzahl kann zum Beispiel 20 Magnete umfassen, welche in einem bestimmten Muster angeordnet sind, wobei jeder Magnet von dem anderen beabstandet ist. Um das vorderseitige Magnetfeld zu erzeugen kann eine zweite Vielzahl von Permanentmagneten radial innerhalb der ersten Vielzahl von Magneten angeordnet sein. Die Vielzahl kann eine entgegengesetzte Polarität zu der zweiten Vielzahl aufweisen. Auch der rückseitige Magnet 301 kann als eine Vielzahl von Magneten ausgestaltet sein, welche hinter der Arbeitsoberfläche 461 der Elektrode in einer vorgebbaren Struktur angeordnet sind.

Der ringförmige vorderseitige Magnet 302 gemäss Fig. 15 weist einen grösseren Durchmesser auf als die runde Arbeitsoberfläche 461 der Elektrode 460. In Ausführung der Erfindung kann der Durchmesser des vorderseitigen Magneten um einen Faktor 1,1 bis 2 grösser sein als der Durchmesser der Elektrode.

Prinzipiell sollte eine Magnetisierung der Magnete weitgehend parallel zur Oberflächennormalen der Arbeitsoberfläche 461 verlaufen. Hierfür können die vorderseitigen Magnete 302 sowohl vor, als auch neben und um die Arbeitsoberfläche 461 angeordnet sein. Auch ist es möglich das ein Magnetkreis aus zwei Magneten besteht, wobei ein Pol vor der Arbeitsoberfläche und ein Pol neben (über oder unter) der Arbeitsoberfläche angeordnet ist. Insbesondere können die vorderseitigen Magneten auch beweglich angeordnet sein, sodass sie ihre Position relativ zur Arbeitsoberfläche ändern können.

Zusammenfassend wir eine Anordnung des Magnets (oder der Magnete) derart vorgenommen, dass eine beliebige Magnetfeldstruktur (Form und Stärke) an der Arbeitsoberfläche der zweidimensionalen Elektrode erzeugt werden kann. Dabei ist es zum Beispiel möglich, dass die Magnetfeldstärke im äusseren Bereich der Arbeitsoberfläche grösser ist als in einem inneren Bereich der Arbeitsoberfläche, aber auch umgekehrt.

Allgemein kann ein erfindungsgemässer Magnet zumindest teilweise als Permanentmagnet ausgestaltet sein, wobei alle typischen Magnetmaterialien wie Hartferrite, AlNiCo, NdFeB, SmCo als Volumenmaterialien oder als kunststoffgebundene Magnete zum Einsatz kommen können. Der Magnet kann aus einem Formkörper gefertigt sein, oder aber segmentiert sein. Typische Magnetfeldstärke welche bei einer erfindungsgemässen Vakuumkammer vorzugsweise verwendet werden haben eine Magnetfeldstärke einer senkrechten Komponente des Magnetfeldes auf der erfindungsgemäßen Elektrode zwischen 0,1 und 100 mT, vorzugsweise 1 bis 50 mT, insbesondere 2 bis 20 mT.

In allen aufgeführten Ausführungsbeispielen kann ein Substrathalter in der Kammer angeordnet sein. Der Substrathalter umfasst vorzugsweise eine Vielzahl von Hochgeschwindigkeitsstahlsubstraten, die in vertikaler Richtung in verschiedenen Höhen angeordnet sind. Der Substrathalter ist rotierbar in der Kammer angeordnet, sodass eine Substrathalterplatte um eine zentrale Achse des Substrathalters rotiert werden kann. Zusätzlich ist jede vertikale Anordnung des Substrats um seine individuelle Achse rotierbar. Die erste Elektrode und sofern vorhanden die zweite Elektrode haben beispielsweise Durchmesser von 100mm und sind in der Kammer an vorgebbaren vertikalen Positionen angeordnet. Um die Effekte an den einzelnen Elektroden und den Magnetfeldern während eines Experimentes zu beobachten, können Messungen an den Elektroden an drei unterschiedlichen Höhen vorgenommen: Bei 210 mm entsprechend einem unteren Ende der zweiten Elektrode B; Bei 340 mm entsprechend 30 mm über einem unterem Ende der ersten Elektrode; und 470 mm entsprechend 60 mm über dem oberen Ende der ersten Elektrode A. Die geätzten Substrate waren Stahlkörper (100Cr6), welche zweifach in der Vakuumkammer rotiert wurden.

In Fig. 17 ist nun eine ähnliche Kammer wie oben beschrieben dargestellt, wobei zusätzlich vorderseitige Magnetfelder an die Elektroden angelegt sind. Die vorderseitigen Magnetfelder der ersten Elektrode 460 (A) und zweiten Elektrode 470 (B) haben entgegengesetzte Polaritäten. Die Magnetfelder können dazu benutz werden, die Plasmaerzeugung in der Nähe der ersten und zweiten Elektrode 460, 470 anzupassen, was durch die Änderung der Richtung der Ströme, welche an die entsprechenden Spulen angelegt werden, erreicht werden kann. Wenn ein Strom von 80 A an die Elektroden angelegt wird, wird der ersten Elektroden 460 (A) ein Strom von 40 A und der zweiten Elektrode 470 (B) ein Strom von 40 A zugeführt. Wie zu sehen ist, bleiben die Ströme an der ersten Elektrode 460 (A) und der zweiten Elektrode 470 (B) nahe bei 40 A, wenn die Polaritäten der Magnetfelder, welche an die Elektroden 460, 470 angelegt, entgegengesetzt orientiert sind. Wenn jedoch die angelegten Magnetfelder dieselbe Polarität haben erreicht der Strom an der ersten Elektrode annährend 80 A, während der Strom an der zweiten Elektrode nahe 0 A ist. Dies kommt daher, dass der Elektronenstrom an der zweiten Elektrode in diesem Fall fast komplett abgeschirmt wird.

Das Diagramm und die Tabelle der Fig. 18 und 20 zeigen die Messungen wie an den vorgegebenen Höhen bei einer Vorrichtung gemäss 17 vorgenommen. Ein Diagramm der Resultate ist in Fig. 18 gezeigt. Die X-Achse repräsentiert die vertikale Position über dem unteren Rand der unteren kreisförmigen Elektrode B (210 mm), oder in anderem Worten, die vorgebbare Höhe gemessen im mm und die Y-Achse repräsentiert die Ätztiefe in nm. Man kann dem Diagramm entnehmen, dass die Substrate, die an höheren senkrechten Positionen an dem Substrathalter vorgesehen sind, ein schwächeres Ätzen der Substrate zeigen als bei denjenigen Substraten, die an niedrigeren Positionen am Substrathalter positioniert sind. Die obere Linie im Diagramm zeigt das Ausführungsbeispiel von Fig. 17; während die unter Linie ein bekanntes System mit einer linearen Elektrode zeigt. Gemäss Fig. 17 in welcher zwei einzelne Elektroden parallel betrieben werden, ist eine signifikant höhere Ätzrate aufgrund eines höheren Substratstromes in der Kammer zu beobachten. Die Homogenität ist jedoch nicht verbessert, wie bei dem Abfall der Ätztiefe mit absteigender Höhe zu sehen ist. Fig. 19 hingegen zeigt ein Ausführungsbeispiel bei welchem über zeitliche Variation der Polarität der Magnete die Homogenität im Vergleich zum Stand der Technik (unter Linie) verbessert wurde. Die X-Achse repräsentiert die vertikale Position über dem unteren Rand der unteren kreisförmigen Elektrode B (210 mm), oder in anderem Worten, die vorgebbare Höhe gemessen im mm und die Y-Achse repräsentiert die Ätztiefe in nm.

Die erste Reihe der Tabelle von Fig. 20, die mit «Stand. » bezeichnet ist, zeigt die Messung, die an einem bekannten System mit einer konventionellen linearen Elektrode vorgenommen wurden. An der linearen Elektrode wurde 80 A angelegt und der Substratstrom wurde zu 1,9 A gemessen. Die Ätztiefe der Bodenmessung (bot, 210mm) ist 250 nm. Die Tiefe bei der mittleren Messung (mid, 340mm) ist 210 nm, was 84% der Bodenätztiefe entspricht, und die Tiefe am oberen Messpunkt (top, 470mm) ist 110 nm, was 48 % der Bodenätztiefe entspricht. Bei den beschriebenen Ausführungen mit zwei einzelnen Elektroden bei denen nur rückseitige Magnetfelder an die Elektroden angelegt wurden, zeigen eine verstärktes Ätzen aufgrund des erhöhten Substratstromes von 3,4 A, es bleiben jedoch dieselben Probleme mit der Homogenität. An jede Elektrode wird ein Strom von 40 A angelegt. Die Ätztiefe bei der Bodenmessung (bot, 210mm) ist 420 nm. Die Ätztiefe bei der mittleren Messung (mid, 340mm) ist 350nm (83%) und die Tiefe bei der oberen Messung (top, 470mm) ist 180 nm (43%). Die nächsten beiden Zeilen zeigen die Resultate wie sie erhalten werden, wenn an die Elektroden Magnetfelder angelegt werden. Wenn Felder mit selber Polarität angelegt werden, beträgt der Strom an der ersten Elektrode 75 A und der Strom an der zweiten Elektrode 5 A. Der Substratstrom ist hoch bei 4,5 A und Ätztiefe an der oberen Messung (470 mm) ist 760nm. Die mittlere Messung (340 mm) ist 620 nm (86%) und die Bodenmessung (340 mm) ist 300 nm (39%). Wenn die Polaritäten durch Umkehrung der Richtung des an die Spule angelegten Stromes geändert werden, ist ein umgekehrt Effekt an der Ätztiefe zu beobachten. Der an die erste Elektrode angelegte Strom ist 49 A und der an die zweite Elektrode angelegte Strom ist 31 A. Der Substratstrom wurde zu 4 A gemessen. Die grösste gemessen Tiefe in dieser Konfiguration findet sich an der Bodenmessung (210 mm) zu 640nm. Die mittlere Messung (340 mm) liefert 490 nm (76%) und die obere Messung (470mm) beträgt 240 nm (38%).

Gewünscht ist es, eine Homogenität in der Kammer zu erreichen, bei welcher die Ätzrate in wesentlichen über die ganze Höhe des Substrathalters konstant ist. Da die Ätzprofile bei derselben Polarität des Magnetfeldes und bei der entgegensetzten Polarität entgegensetzte Tendenzen von oben nach unten zeigen, kann Homogenität dadurch erreicht werden, dass man die Ätzprofile zu bestimmen Zeitintervallen überlagert. Die gewählte Zeit kann kurz sein, wie zum Beispiel 1 bis 10 Umdrehungen des Substrathalters oder länger, falls gewünscht. Im Beispiel der Konfiguration gemäss Fig. 17 wurde gefunden, dass eine gute Homogenität erreicht werden kann wenn 2/3 der Prozesszeit (z.B. 40 min) bei Anlegen von vorderseitigen Magnetfeldern gleicher Polarität verwendet wird (wie in der dritten Reihe der Ergebnisse gemäss Fig. 20 und obere Kurve Fig. 19) und 1/3 der Prozesszeit (20 min) vorderseitige Magnetfelder mit entgegengesetzter Polarität verwendet werden (wie in der 4. Reihe der Ergebnisse in Fig. 20 gezeigt).

Während unterschiedliche beispielhafte Konfigurationen im Rahmen dieser Anmeldung gezeigt und beschrieben wurden, fallen natürlich auch weitere Ausführungsbeispiele mit jeglicher Anzahl von Verdampfern und jeglicher Anzahl von Elektroden in den Schutzbereich der hier beanspruchten Erfindung. Darüber hinaus kann ein erfindungsgemässes lonenätzsystem mit einer Vielzahl von einzelnen Elektroden ausgerüstet sein, wobei verschiedene Elektroden mit verschiedenen Strömen versorgt sein können. An die verschiedenen Elektroden können gleiche oder verschiedene Ströme, auch zu verschiedenen Zeiten angelegt werden um die Plasmaaktivierung und das Ätzen in gewünschter Weise zu manipulieren.

Obwohl im Rahmen der vorliegenden Anmeldung bereits eine ganze Reihe von Ausführungsbeispielen beschrieben wurde, versteht es sich von selbst, dass weitere Variationen möglich sind. Zum Beispiel können die beschrieben Ausführungsformen in geeigneter Weise kombiniert und ergänzt werden bzw. durch gleichwirkende äquivalente Merkmale ersetzt werden so lange dies unter den Schutzbereich der Erfindung fällt. Der Schutzbereich der Erfindung ist durch die Ansprüche definiert.

## Patentansprüche

1. Vakuumkammer zur Durchführung einer Plasmabehandlung umfassend einen Plasmabehandlungsbereich, der von Kammerwänden umschlossen ist, sowie eine Plasmaquelle umfassend:
mindestens eine in der Vakuumkammer (100, 200, 300, 400) angeordnete Kathode (110, 210, 220, 310, 320, 330, 450) zur kathodischen Vakuumbogenverdampfung mit einer Bogenanode welche mit der Vakuumkammer (100, 200, 300, 400) verbunden ist; eine vor der Kathode anordnenbare Abschirmung (115, 230, 332, 333, 334);
mindestens eine in der Vakuumkammer (100, 200, 300, 400) angeordnete Elektrode (30,120, 120a, 130, 140, 240, 250, 340, 350, 360, 460, 470), wobei die Elektrode (30,120, 120a, 130, 140, 240, 250, 340, 350, 360, 460, 470) eine Arbeitsoberfläche (461) zum Auffangen der von der Kathode (110, 210, 220, 310, 320, 330, 450) emittierten Elektronen umfasst; und
die Arbeitsoberfläche (461) eine zweidimensionale Oberfläche zum Auffangen der von der Kathode (110, 210, 220, 310, 320, 330, 450) emittierten Elektronen ist, und die zweidimensionale Oberfläche eine zu einer Oberflächennormale erste orthogonale Ausdehnung und eine zweite orthogonale Ausdehnung besitzt, wobei die erste orthogonale Ausdehnung senkrecht zu der zweiten orthogonalen Ausdehnung verläuft, **dadurch gekennzeichnet, dass** ein Längenverhältnis der ersten orthogonalen Ausdehnung zu der zweiten orthogonalen Ausdehnung zwischen 0,1 und 1 liegt; und mindestens ein Magnet (301, 302, 480, 490) zum Erzeugen eines Magnetfeldes,
welches auf die Arbeitsoberfläche (461) der Elektrode (30,120, 120a, 130, 140, 240, 250, 340, 350, 360, 460, 470) einwirkt, in, an oder in und an der Vakuumkammer (100, 200, 300, 400) angeordnet ist, wobei der Magnet (301, 302, 480, 490) einen vorderseitigen Magneten (302) und / oder einen rückseitigen Magneten (301, 480, 490) umfasst, wobei der vorderseitige Magnet (302) im Bereich der Arbeitsoberfläche (461) zum Erzeugen eines vorderseitigen Magnetfeldes angeordnet ist und der rückseitige Magnet (301, 480, 490) hinter der Arbeitsoberfläche (461) zum Erzeugen eines rückseitigen Magnetfeldes angeordnet ist.

2. Vakuumkammer nach Anspruch 1, wobei der vorderseitige Magnet (302) vor der Arbeitsoberfläche (461) angeordnet ist und / oder der vorderseitige Magnet (302) zumindest teilweise neben oder um die Arbeitsoberfläche (461) angeordnet ist und / oder wobei der vorderseitige Magnet (302) und / oder der rückseitige Magnet (301, 480, 490) in der Vakuumkammer (100, 200, 300, 400) angeordnet ist, oder der rückseitige Magnet (301, 480, 490) ausserhalb der Vakuumkammer (100, 200, 300, 400) angeordnet ist.

3. Vakuumkammer nach einem der Ansprüche 1 bis 2, wobei der vorderseitige Magnet (302) und / oder der rückseitige Magnet (301, 480, 490) einen Permanentmagnet und / oder einen Elektromagnet umfassen oder der vorderseitige Magnet (302) und / oder der rückseitige Magnet (301, 480, 490) als eine an die Elektrode (30,120, 120a, 130, 140, 240, 250, 340, 350, 360, 460, 470) gekoppelte, elektromagnetische Spule (480, 490) ausgestaltet ist.

4. Vakuumkammer nach einem der vorrangehenden Ansprüche umfassend eine erste Elektrode mit einer ersten Arbeitsoberfläche zum Auffangen der von der Kathode (110, 210, 220, 310, 320, 330, 450) emittierten Elektronen und eine zweite Elektrode mit einer zweiten Arbeitsoberfläche zum Auffangen der von der Kathode (110, 210, 220, 310, 320, 330, 450) emittierten Elektronen und / oder eine Vielzahl von Kathoden (110, 210, 220, 310, 320, 330, 450).

5. Vakuumkammer nach einem der Ansprüche 1 bis 4, umfassend eine Vielzahl von Elektroden (30,120, 120a, 130, 140, 240, 250, 340, 350, 360, 460, 470), wobei an mindestens einer der Elektroden (30,120, 120a, 130, 140, 240, 250, 340, 350, 360, 460, 470) der vor der Arbeitsoberfläche (461) angeordnete vorderseitige Magnet (302) und der hinter der Arbeitsoberfläche (461) angeordneten rückseitige Magnet (301, 480, 490) angeordnet ist.

6. Vakuumkammer nach einem der Ansprüche 1 bis 5, wobei der vorderseitige Magnet (302) und der rückseitige Magnet (301, 480, 490), Elektromagneten sind und die Vakuumkammer (100, 200, 300, 400) weiter eine Stromquelle umfasst, welche mit dem rückseitigen Magnet (302) und dem vorderseitigen Magnet (301, 480, 490) verbunden ist, wobei die Stromquelle derart ausgestaltet ist, dass ein Stromfluss zu dem rückseitigen Magnet (302) und dem vorderseitigen Magneten (301, 480, 490) so eingestellt werden kann, dass eine Polarität des rückseitigen und des vorderseitigen Magneten umkehrbar ist.

7. Vakuumkammer nach Anspruch 5 oder 6, wobei die Vielzahl von Elektroden (30,120, 120a, 130, 140, 240, 250, 340, 350, 360, 460, 470) mit einem gemeinsamen Netzteil verbunden sind oder die Vielzahl von Elektroden (30,120, 120a, 130, 140, 240, 250, 340, 350, 360, 460, 470) eine erste Gruppe von Elektroden (30,120, 120a, 130, 140, 240, 250, 340, 350, 360, 460, 470) umfasst, welche mit einem ersten Netzteil verbunden ist und eine zweite Gruppe von Elektroden (30,120, 120a, 130, 140, 240, 250, 340, 350, 360, 460, 470) umfasst, welche mit einem zweiten Netzteil verbunden ist.

8. Vakuumkammer nach Anspruch 4, wobei im Bereich der ersten Arbeitsoberfläche, insbesondere vor und / oder neben und / oder um die erste Arbeitsoberfläche, ein erster vorderseitiger Magnet zum Erzeugen eines vorderseitigen Magnetfeldes angeordnet ist und hinter der zweiten Arbeitsoberfläche ein zweiter rückseitiger Magnet zum Erzeugen eines zweiten rückseitigen Magnetfeldes angeordnet ist.

9. Vakuumkammer nach einem der vorrangehenden Ansprüche, wobei eine Magnetfeldstärke einer senkrechten Komponente auf der Elektrode (30,120, 120a, 130, 140, 240, 250, 340, 350, 360, 460, 470) zwischen 0,1 und 100 mT, vorzugsweise 1 bis 50 mT, insbesondere 2 bis 20 mT beträgt.

## Claims

1. A vacuum chamber for performing a plasma treatment comprising a plasma treatment area which is enclosed by chamber walls, and a plasma source comprising:
at least one cathode (110, 210, 220, 310, 320, 330, 450) arranged in the vacuum chamber (100, 200, 300, 400) for cathodic vacuum arc evaporation with an arc anode which is connected to the vacuum chamber (100, 200, 300, 400);
a shield (115, 230, 332, 333, 334) which can be arranged in front of the cathode;
at least one electrode (30, 120, 120a, 130, 140, 240, 250, 340, 350, 360, 460, 470) arranged in the vacuum chamber (100, 200, 300, 400), wherein the electrode (30, 120, 120a, 130, 140, 240, 250, 340, 350, 360, 460, 470) comprises a working surface (461) for collecting the electrons emitted from the cathode (110, 210, 220, 310, 320, 330, 450); and
the working surface (461) is a two-dimensional surface for collecting the electrons emitted from the cathode (110, 210, 220, 310, 320, 330, 450), and the two-dimensional surface has a first orthogonal extension and a second orthogonal extension to a surface normal, wherein the first orthogonal extension is perpendicular to the second orthogonal extension,
**characterized in that** a length ratio of the first orthogonal extension to the second orthogonal extension is between 0.1 and 1; and
at least one magnet (301, 302, 480, 490) for generating a magnetic field which acts on the working surface (461) of the electrode (30, 120, 120a, 130, 140, 240, 250, 340, 350, 360, 460, 470) is arranged in, on or in and on the vacuum chamber (100, 200, 300, 400), wherein the magnet (301, 302, 480, 490) comprises a front-side magnet (302) and / or a rear-side magnet (301, 480, 490), wherein the front-side magnet (302) is arranged in the area of the working surface (461) for generating a front-side magnetic field and the rear-side magnet (301, 480, 490) is arranged behind the working surface (461) for generating a rear-side magnetic field.

2. A vacuum chamber according to claim 1, wherein the front-side magnet (302) is arranged in front of the working surface (461) and / or the front-side magnet (302) is arranged at least partially next to or around the working surface (461) and / or wherein the front-side magnet (302) and / or the rear-side magnet (301, 480, 490) is arranged in the vacuum chamber (100, 200, 300, 400), or the rear-side magnet (301, 480, 490) is arranged outside the vacuum chamber (100, 200, 300, 400).

3. A vacuum chamber according to anyone of the claims 1 to 2, wherein the front-side magnet (302) and / or the rear-side magnet (301, 480, 490) comprise a permanent magnet and / or an electromagnet, or the front-side magnet (302) and / or the rear-side magnet (301, 480, 490) is designed as an electromagnetic coil (480, 490) coupled to the electrode (30, 120, 120a, 130, 140, 240, 250, 340, 350, 360, 460, 470).

4. A vacuum chamber according to anyone of the preceding claims comprising a first electrode having a first working surface for collecting the electrons emitted from the cathode (110, 210, 220, 310, 320, 330, 450) and a second electrode having a second working surface for collecting the electrons emitted from the cathode (110, 210, 220, 310, 320, 330, 450) and / or a plurality of cathodes (110, 210, 220, 310, 320, 330, 450).

5. A vacuum chamber according to anyone of the claims 1 to 4 comprising a plurality of electrodes (30,120, 120a, 130, 140, 240, 250, 340, 350, 360, 460, 470), wherein the front-side magnet (302) arranged in front of the working surface (461) and the rear-side magnet (301, 480, 490) arranged behind the working surface (461) are arranged on at least one of the electrodes (30,120, 120a, 130, 140, 240, 250, 340, 350, 360, 460, 470).

6. A vacuum chamber according to anyone of the claims 1 to 5, wherein the front-side magnet (302) and the rear-side magnet (301, 480, 490) are electromagnets, and the vacuum chamber (100, 200, 300, 400) further comprises a current source which is connected to the rear-side magnet (302) and the front-side magnet (301, 480, 490), wherein the current source is designed in such a way that a current flow to the rear-side magnet (302) and the front-side magnet (301, 480, 490) can be adjusted such that a polarity of the rear-side magnet and the front-side magnet can be reversed.

7. A vacuum chamber according to claim 5 or 6, wherein the plurality of electrodes (30,120, 120a, 130, 140, 240, 250, 340, 350, 360, 460, 470) is connected to a common power supply or the plurality of electrodes (30,120, 120a, 130, 140, 240, 250, 340, 350, 360, 460, 470) comprises a first group of electrodes (30, 120, 120a, 130, 140, 240, 250, 340, 350, 360, 460, 470) which is connected to a first power supply and comprises a second group of electrodes (30, 120, 120a, 130, 140, 240, 250, 340, 350, 360, 460, 470) which is connected to a second power supply.

8. A vacuum chamber according to claim 4, wherein a first front-side magnet for generating a front-side magnetic field is arranged in the area of the first working surface, in particular in front of and / or next to and / or around the first working surface, and a second rear-side magnet for generating a second rear-side magnetic field is arranged behind the second working surface.

9. A vacuum chamber according to anyone of the preceding claims, wherein a magnetic field strength of a perpendicular component on the electrode (30,120, 120a, 130, 140, 240, 250, 340, 350, 360, 460, 470) is between 0.1 and 100 mT, preferably 1 to 50 mT, in particular 2 to 20 mT.

## Revendications

1. Chambre à vide pour effectuer un traitement au plasma comprenant une zone de traitement au plasma qui est entourée par des parois de chambre, ainsi qu'une source de plasma comprenant :
au moins une cathode (110, 210, 220, 310, 320, 330, 450) disposée dans la chambre à vide (100, 200, 300, 400) pour l'évaporation cathodique par arc sous vide avec une anode d'arc reliée à la chambre à vide (100, 200, 300, 400) ; un blindage (115, 230, 332, 333, 334) pouvant être placé devant la cathode ;
au moins une électrode (30, 120, 120a, 130, 140, 240, 250, 340, 350, 360, 460, 470) disposée dans la chambre à vide (100, 200, 300, 400), l'électrode (30, 120, 120a, 130, 140, 240, 250, 340, 350, 360, 460, 470) comprenant une surface de travail (461) pour collecter les électrons émis par la cathode (110, 210, 220, 310, 320, 330, 450) ; et
la surface de travail (461) étant une surface bidimensionnelle pour collecter les électrons émis par la cathode (110, 210, 220, 310, 320, 330, 450), et la surface bidimensionnelle ayant une première extension orthogonale à une normale de surface et une deuxième extension orthogonale, la première extension orthogonale étant perpendiculaire à la deuxième extension orthogonale, **caractérisé en ce qu'**un rapport de longueur de la première extension orthogonale à la deuxième extension orthogonale est compris entre 0,1 et 1 ; et
au moins un aimant (301, 302, 480, 490) pour générer un champ magnétique agissant sur la surface de travail (461) de l'électrode (30, 120, 120a, 130, 140, 240, 250, 340, 350, 360, 460, 470) étant disposé dans, sur ou dans et sur la chambre à vide (100, 200, 300, 400), l'aimant (301, 302, 480, 490) comprenant un aimant avant (302) et/ou un aimant arrière (301, 480, 490), l'aimant avant (302) étant disposé dans la zone de la surface de travail (461) pour générer un champ magnétique avant et l'aimant arrière (301, 480, 490) étant disposé derrière la surface de travail (461) pour générer un champ magnétique arrière.

2. Chambre à vide selon la revendication 1, l'aimant avant (302) étant disposé devant la surface de travail (461) et/ou l'aimant avant (302) étant disposé au moins partiellement à côté ou autour de la surface de travail (461) et/ou l'aimant avant (302) et/ou l'aimant arrière (301, 480, 490) étant disposés dans la chambre à vide (100, 200, 300, 400) ou l'aimant arrière (301, 480, 490) étant disposé à l'extérieur de la chambre à vide (100, 200, 300, 400).

3. Chambre à vide selon l'une des revendications 1 à 2, l'aimant avant (302) et/ou l'aimant arrière (301, 480, 490) comprenant un aimant permanent et/ou un électroaimant ou l'aimant avant (302) et/ou l'aimant arrière (301, 480, 490) étant conçu comme une bobine électromagnétique (480, 490) couplée à l'électrode (30, 120, 120a, 130, 140, 240, 250, 340, 350, 360, 460, 470).

4. Chambre à vide selon l'une des revendications précédentes, comprenant une première électrode ayant une première surface de travail pour collecter les électrons émis par la cathode (110, 210, 220, 310, 320, 330, 450) et une deuxième électrode ayant une deuxième surface de travail pour collecter les électrons émis par la cathode (110, 210, 220, 310, 320, 330, 450) et/ou une pluralité de cathodes (110, 210, 220, 310, 320, 330, 450).

5. Chambre à vide selon l'une des revendications 1 à 4, comprenant une pluralité d'électrodes (30, 120, 120a, 130, 140, 240, 250, 340, 350, 360, 460, 470), l'aimant avant (302) disposé devant la surface de travail (461) et l'aimant arrière (301, 480, 490) disposé derrière la surface de travail (461) étant disposés sur au moins l'une des électrodes (30, 120, 120a, 130, 140, 240, 250, 340, 350, 360, 460, 470).

6. Chambre à vide selon l'une des revendications 1 à 5, l'aimant avant (302) et l'aimant arrière (301, 480, 490) étant des électroaimants et la chambre à vide (100, 200, 300, 400) comprenant en outre une source de courant reliée à l'aimant arrière (302) et à l'aimant avant (301, 480, 490), la source de courant étant conçue de telle sorte qu'un flux de courant vers l'aimant arrière (302) et l'aimant avant (301, 480, 490) puisse être réglé de telle sorte qu'une polarité de l'aimant arrière et de l'aimant avant puisse être inversée.

7. Chambre à vide selon la revendication 5 ou 6, la pluralité d'électrodes (30, 120, 120a, 130, 140, 240, 250, 340, 350, 360, 460, 470) étant reliées à une alimentation électrique commune ou la pluralité d'électrodes (30, 120, 120a, 130, 140, 240, 250, 340, 350, 360, 460, 470) comprenant un premier groupe d'électrodes (30, 120, 120a, 130, 140, 240, 250, 340, 350, 360, 460, 470) relié à une première alimentation électrique et un deuxième groupe d'électrodes (30, 120, 120a, 130, 140, 240, 250, 340, 350, 360, 460, 470) relié à une deuxième alimentation électrique.

8. Chambre à vide selon la revendication 4, un premier aimant avant destiné à générer un champ magnétique avant étant disposé dans la zone de la première surface de travail, en particulier devant et/ou à côté et/ou autour de la première surface de travail, et un deuxième aimant arrière destiné à générer un deuxième champ magnétique arrière étant disposé derrière la deuxième surface de travail.

9. Chambre à vide selon l'une des revendications précédentes, une intensité de champ magnétique d'une composante perpendiculaire sur l'électrode (30, 120, 120a, 130, 140, 240, 250, 340, 350, 360, 460, 470) étant comprise entre 0,1 et 100 mT, de préférence entre 1 et 50 mT, en particulier entre 2 et 20 mT.
